# EUROPEAN PATENT APPLICATION

(11) **EP 1 843 386 A1**
(43) Date of publication of application: **10.10.2007**
(21) Application number: 06711874.5
(22) Date of filing: 18.01.2006
(51) Int. Cl.: H01L 21/027, G03F 7/20

(54) **LIQUID REMOVING APPARATUS, EXPOSURE APPARATUS AND DEVICE MANUFACTURING METHOD**

(30) Priority: 18.01.2005 JP 2005010093
(71) Applicant: NIKON CORPORATION, Tokyo 100-8331 (JP)
(72) Inventor: MIZUTANI, Takeyuki c/o NIKON CORPORATION,, Chiyoda-ku, Tokyo, 1008331 (JP)
(74) Representative: HOFFMANN EITLE
(86) International application number: PCT/JP2006/300605
(87) International publication number: WO 2006/077859

(57) **Abstract**

A liquid removing apparatus (1) evacuates a gas present in a specified space formed on a rear surface (Pb) side of a substrate (P) taken out from a substrate holder (PH), to remove liquid adhered to the rear surface (Pb) of an exposure target substrate (P).

## Description

### TECHNICAL FIELD

The present invention relates to a liquid removing apparatus for removing liquid adhered to an exposure target substrate, an exposure apparatus provided with the liquid removing apparatus and a device fabricating method.

This application claims priority to Japanese Patent Application No. 2005-10093 filed on January 18, 2005, the content of which is incorporated herein by reference.

### BACKGROUND ART

In a photolithography process, one of the processes for fabricating a micro device such as a semiconductor device and liquid crystal device, use is made of an exposure apparatus that transfers a pattern formed on a mask to a photosensitive substrate. The exposure apparatus includes a mask stage capable of holding and moving a mask and a substrate stage having a substrate holder for holding a substrate and capable of displacing the substrate holder that holds the substrate. The exposure apparatus is adapted to project a pattern image of the mask on the substrate through a projection optical system while sequentially moving the mask stage and the substrate stage. In the manufacture of micro devices, miniaturization of a pattern formed on the substrate is required to increase density of the devices. In order to comply with such a requirement, there is a need to further enhance a resolution power of the exposure apparatus. As means for assuring the enhanced resolution power, there has been proposed a liquid immersion exposure apparatus that fills a light path space between a projection optical system and a substrate with liquid and exposes the substrate through the liquid, such as that disclosed in Patent Document 1 below.

Patent Document 1: PCT International Publication No. WO 99/49504.

### DISCLOSURE OF INVENTION

### PROBLEMS TO BE SOLVED BY THE INVENTION

In case a substrate held on a substrate holder is exposed through liquid, there is a possibility that the liquid reaches over into the side of a rear surface of the substrate to adhere thereto. If the liquid is left adhered to the rear surface of the substrate, damages can most likely be widely spread due to, e.g., the liquid being adhered to a conveyor system used for taking out the substrate from a substrate holder and then being splashed into a conveying route of the conveyor system.

The present invention has been made in view of such circumstances, and it is an object of the present invention to provide a liquid removing apparatus capable of reliably removing the liquid adhered to a substrate which has been exposed through the liquid. Another object of the present invention is to provide an exposure apparatus provided with the liquid removing apparatus. A further object of the present invention is to provide a device fabricating method for fabricating devices by use of the exposure apparatus.

### MEANS FOR SOLVING THE PROBLEM

In order to achieve these objects, the present invention employs the following configurations summarized below in conjunction with the drawings that illustrate embodiments. In this regard, reference numerals in parentheses are attached to individual elements merely for the purpose of illustration and are not intended to limit the respective elements.

In accordance with a first aspect of the present invention, there is provided a liquid removing apparatus (1) that removes liquid (LQ) adhered to an exposure target substrate (P) irradiated with exposure light (EL) through the liquid (LQ) and taken out from a substrate holder (PH), wherein a specified space (8) is formed on a rear surface (1b) side of the exposure target substrate (P) taken out from the substrate holder (PH), and wherein the liquid (LQ) adhered to a rear surface (1b) of the exposure target substrate (P) is removed by evacuating a gas present in the specified space through a suction port (5).

Further, in accordance with the first aspect of the present invention, it may possible to reliably remove the liquid adhered to the rear surface of the substrate taken out from the substrate holder.

In accordance with a second aspect of the present invention, there is provided an exposure apparatus (EX), which includes a substrate holder (PH) and the liquid removing apparatus (1) of the first aspect.

Further, in accordance with the second aspect of the present invention, it may be possible to reliably remove the liquid adhered to the exposure target substrate exposed.

In accordance with a third aspect of the present invention, there is provided a device fabricating method including a step of using the exposure apparatus (EX) of the above aspects..

Further, in accordance with the third aspect of the present invention, it may be possible to manufacture devices with a desired performance from the exposure target substrate from which the liquid has been removed.

### EFFECTS OF THE INVENTION

In accordance with the present invention, it may be possible to reliably remove liquid adhered to a substrate that has been exposed through the liquid.

### BRIEF DESCRIPTION OF THE DRAWINGS

FIG. 1 is a schematic diagram showing one embodiment of an exposure apparatus provided with a liquid removing apparatus.
FIG. 2A is a sectional side view showing a first embodiment of a liquid removing apparatus.
FIG. 2B is a plan view showing the first embodiment of the liquid removing apparatus.
FIG. 3 is an enlarged sectional side view showing major parts of the liquid removing apparatus in accordance with the first embodiment.
FIG. 4A is a view for explaining an operation of the liquid removing apparatus in accordance with the first embodiment.
FIG. 4B is a view for explaining the operation of the liquid removing apparatus in accordance with the first embodiment.
FIG. 4C is a view for explaining the operation of the liquid removing apparatus in accordance with the first embodiment.
FIG. 5A is a perspective view showing a conveyor system for conveying a substrate.
FIG. 5B is a side view showing the conveyor system for conveying the substrate.
FIG. 6A is a sectional side view illustrating a second embodiment of the liquid removing apparatus.
FIG. 6B is a plan view showing the second embodiment of the liquid removing apparatus.
FIG. 7 is an enlarged sectional side view showing major parts of the liquid removing apparatus in accordance with the second embodiment.
FIG. 8 is a plan view showing a third embodiment of the liquid removing apparatus.
FIG. 9A an enlarged perspective view showing major parts of the liquid removing apparatus in accordance with the third embodiment.
FIG. 9B is a cross-section view showing the third embodiment of the liquid removing apparatus.
FIG. 10 is a plan view showing a fourth embodiment of the liquid removing apparatus.
FIG. 11 is a cross-section view taken along arrow line B-B in FIG. 10.
FIG. 12 is a plan view showing a modified example of the fourth embodiment of the liquid removing apparatus.
FIG. 13 is a view showing an exposure apparatus main body.
FIG. 14 is a flowchart showing one example of a micro device fabricating process.

### DESCRIPTION OF THE REFERENCE SYMBOLS

1... liquid removing apparatus, 2...base member, 3... upper surface,
4... protruding portions, 5...suction port, 8... specified space,
8A to 8H... mutually-adjoining partition spaces, 9... edge flow path,
9'... flow paths, 10... holder mechanism, 13...first guide members,
14... second guide members, 15... guide members, 500... external space,
Eb... edge region, EL... exposure light, EX... exposure apparatus main body,
EX-SYS... exposure apparatus, G1... gap, G2... gap,
H... first conveyor system, H2... second conveyor system, LQ... liquid,
P... substrate, Pb... rear surface, PH... substrate holder

### BEST MODE FOR CARRYING OUT THE INVENTION

Hereinbelow, embodiments of the present invention will be described with reference to the accompanying drawings, but the present invention will not be limited to these embodiments. In the following description, an XYZ orthogonal coordinate system will be set in the drawings and a positional relationship between individual members will be described with reference to the XYZ orthogonal coordinate system. Furthermore, rotational directions (inclination directions) about an X-axis, a Y-axis and a Z-axis will be respectively referred to as θX, θY and θZ directions. Moreover, an XY plane is parallel to a horizontal plane and the z-axis is an axis extending in a vertical direction.

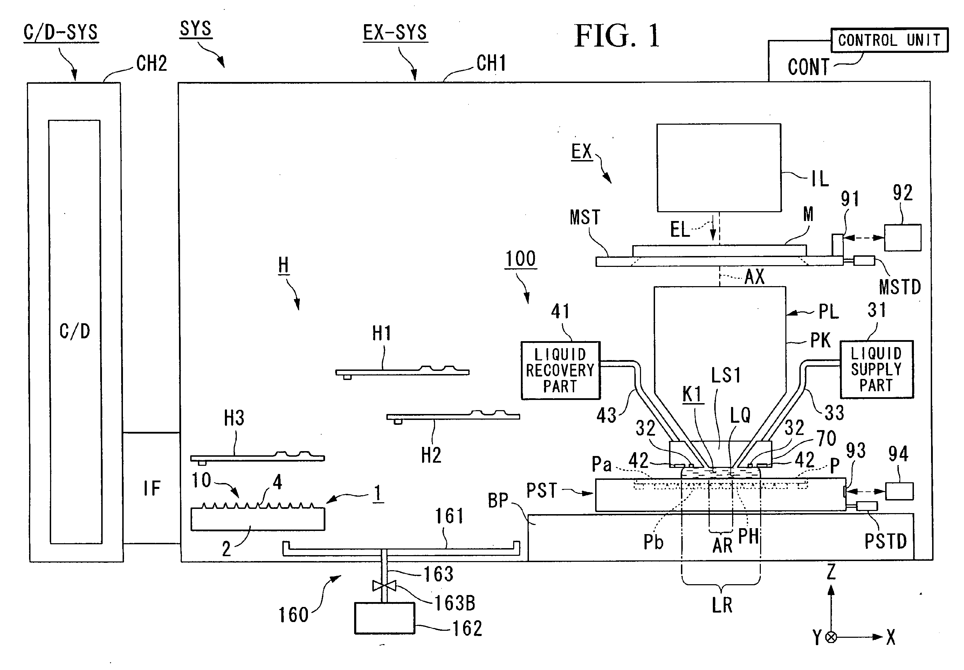

FIG. 1 is a schematic diagram showing one example of a device fabricating system SYS provided with an exposure apparatus EX-SYS. Referring to FIG. 1, the device fabricating system SYS includes an exposure apparatus EX-SYS and a coater/developer apparatus C/D-SYS. The exposure apparatus EX-SYS includes an interface part IF forming a connection portion connecting it to the coater/developer apparatus C/D-SYS, an exposure apparatus main body EX for performing exposure of a substrate P and a control unit CONT for generally controlling overall operations of the exposure apparatus EX-SYS.

The exposure apparatus main body EX includes a mask stage MST for holding and moving a mask M, a substrate stage PST having a substrate holder PH for holding the substrate P in place and capable of displacing the substrate holder PH that holds the substrate P, an illumination optical system IL for illuminating exposure light EL on the mask M held by the mask stage MST and a projection optical system PL for projecting a pattern image of the mask M illuminated with the exposure light EL on the substrate P held by the substrate stage PST. The exposure apparatus main body EX is installed within a first chamber apparatus CH1 whose level of cleanliness is controlled. The exposure apparatus main body EX irradiates the exposure light EL on a front surface Pa of the substrate P while a rear surface Pb of the substrate P is held by the substrate holder PH. The term "substrate" used herein includes a base member such as a semiconductor wafer whose surface is coated with a photosensitive material, and the term "mask" includes a reticle formed with a device pattern which is to be reduction-projected on the substrate.

The exposure apparatus main body EX of the present embodiment is a liquid immersion exposure apparatus that fills a light path space K1 of the exposure light EL between the projection optical system PL and the substrate P with liquid LQ and exposes the substrate P by irradiating the exposure light EL on the substrate P through the projection optical system PL and the liquid LQ. The exposure apparatus main body EX is provided with a liquid immersion mechanism 100 for filling the liquid LQ into the light path space K1 of the exposure light EL between the projection optical system PL and the substrate P. The liquid immersion mechanism 100 includes: a nozzle member 70 arranged in the vicinity of an image plane of the projection optical system PL and having supply ports 32 for supply of the liquid LQ and recovery ports 42 for recovery of the liquid LQ; a liquid supply part 31 for supplying the liquid LQ to an image plane side of the projection optical system PL through a supply pipe 33 and the supply ports 32 provided in the nozzle member 70; and a liquid recovery part 41 for recovering the liquid LQ on the image plane side of the projection optical system PL through the recovery ports 42 of the nozzle member 70 and a recovery pipe 43. Inside the nozzle member 70, there are provided a supply flow path for interconnecting the supply ports 32 and the supply pipe 33 and a recovery flow path for interconnecting the recovery ports 42 and the recovery pipe 43. Furthermore, the exposure apparatus main body EX of the present embodiment adopts a local immersion method by which a liquid immersion region LR of the liquid LQ larger than a projection region AR but smaller than the substrate P is locally formed by use of the liquid LQ on a part of the substrate P including the projection region AR of the projection optical system PL. The control unit CONT is adapted to supply a prescribed quantity of liquid LQ to the substrate P by use of the liquid supply part 31 of the liquid immersion mechanism 100 and recover a prescribed quantity of liquid LQ exiting on the substrate P by use of the liquid recovery part 41, thereby filling the liquid LQ into the light path space K1 between the projection optical system PL and the substrate P. In the exposure apparatus main body EX, the pattern of the mask M is transferred to the substrate P by allowing the exposure light EL passed through the mask M to be irradiated on the substrate P via the projection optical system PL and the liquid LQ existing between the projection optical system PL and the substrate P. In the present embodiment, pure water or purified water is used as the liquid LQ filled into the light path space K1 of the exposure light EL.

The exposure apparatus EX-SYS further includes a conveyor system H for conveying the substrate P between the interface part IF and the exposure apparatus main body EX and a liquid removing apparatus 1 provided on a substrate conveying route of the conveyor system H for removing the liquid LQ adhered to the substrate P which has been subjected to a liquid immersion exposure treatment or process.

The coater/developer apparatus C/D-SYS includes a coating unit (not shown) for coating a photosensitive material on a base member of an unexposed substrate P and a developing unit (not shown) for developing the substrate P which has been exposed in the exposure apparatus main body EX. The coating unit and the developing unit are provided within a second chamber apparatus CH2 installed independently of the first chamber apparatus CH1. The first chamber apparatus CH1 for accommodating the exposure apparatus main body EX and the second chamber apparatus CH2 for containing the coating unit and the developing unit are connected with each other through the interface part IF. In the following description, the coating unit and the developing unit installed in the second chamber apparatus CH2 are collectively referred to as a "coater/developer main body C/D".

The conveyor system H includes a first conveyor system H1 for putting (loading) an unexposed substrate P onto the substrate holder PH of the substrate stage PST, a second conveyor system H2 for conveying the substrate P between the substrate holder PH and the liquid removing apparatus 1, and a third conveyor system H3 for conveying the substrate P between the liquid removing apparatus 1 and the interface part IF. The second conveyor system H2 takes out (unloads) an exposed substrate P from the substrate holder PH and then conveys it to the liquid removing apparatus 1.

The first, second and third conveyor systems H1, H2 and H3 are provided inside the first chamber apparatus CH1. The substrate P on which a photosensitive material has been coated by the coating unit of the coater/developer main body C/D is transferred to the third conveyor system H3 through the interface part IF. The third conveyor system H3 transfers the unexposed substrate P to the first conveyor system H1. The third conveyor system H3 may transfer the substrate P to the first conveyor system H1 through the liquid removing apparatus 1 or may transfer the substrate P to the first conveyor system H1 through a separate conveyor system or a relay device but not through the liquid removing apparatus 1. Alternatively, the third conveyor system H3 may directly transfer the substrate P to the first conveyor system H1. The first conveyor system H1 loads the unexposed substrate P onto the substrate holder PH of the exposure apparatus main body EX. The substrate P exposed in the exposure apparatus main body EX is unloaded from the substrate holder PH by means of the second conveyor system H2. The second conveyor system H2 conveys the unloaded substrate P to the liquid removing apparatus 1. The liquid removing apparatus 1 performs a treatment or processing for removing the liquid LQ adhered to the substrate P unloaded from the substrate holder PH. The third conveyor system H3 receives the substrate P from the liquid removing apparatus 1 and conveys it to the interface part IF. The substrate P conveyed to the interface part IF is transported to the developing unit of the coater/developer main body C/D. The developing unit performs a developing treatment or process for the substrate P thus received.

### <First Embodiment of Liquid Removing Apparatus>

Next, description will be made on a first embodiment of the liquid removing apparatus 1. After the substrate P held on the substrate holder PH is exposed through the liquid LQ in the exposure apparatus main body EX, the control unit CONT removes the liquid LQ on the front surface Pa of the substrate P by use of the liquid recovery part 41 of the liquid immersion mechanism 100. However, the liquid LQ reached over to the rear surface Pb of the substrate P may possibly be taken out from the substrate holder PH by remaining to be adhered to the rear surface Pb of the substrate P. For this reason, after the substrate P irradiated with the exposure light EL through the liquid LQ is taken out from the substrate holder PH by means of the second conveyor system H2, the control unit CONT removes the liquid LQ adhered to the substrate P by use of the liquid removing apparatus 1. The liquid removing apparatus 1 is provided with a holder mechanism 10 for holding the substrate P taken out from the substrate holder PH and serves to remove the liquid LQ adhered to the rear surface Pb of the substrate P.

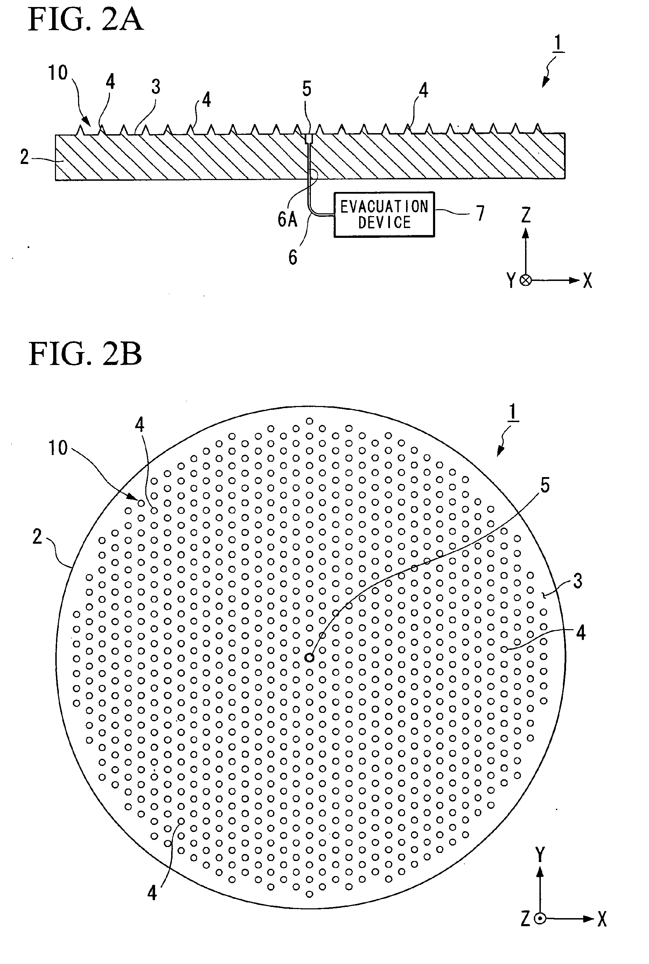

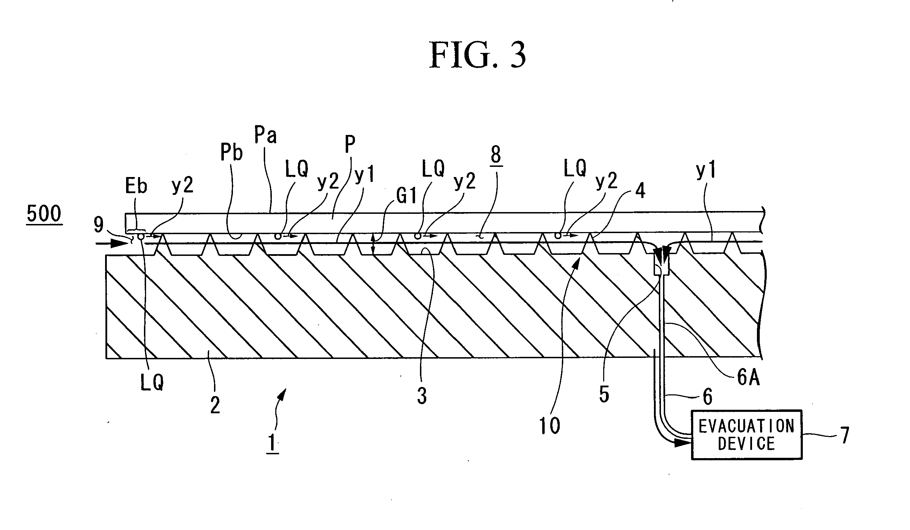

FIG. 2A is a sectional side view illustrating a first embodiment of the liquid removing apparatus 1 and FIG. 2B is a top plan view thereof. FIG. 3 is an enlarged sectional side view depicting major parts of the liquid removing apparatus 1 in which the substrate P is held in place by the holder mechanism 10.

Referring to FIGS. 2A, 2B and 3, the liquid removing apparatus 1 includes a base member 2, a plurality of protruding portions 4 provided on an upper surface 3 of the base member 2, a suction port 5 formed on the upper surface 3 of the base member 2 and an evacuation device 7 connected to the suction port 5 via a flow path 6. The evacuation device 7 includes a vacuum system such as a vacuum pump. The base member 2 has a generally circular shape when seen from the top. The upper surface 3 is provided in a substantially parallel relationship with an XY plane (horizontal plane).

The protruding portions 4 serve to support the rear surface Pb of the substrate P and form a part of the holder mechanism 10. The protruding portions 4 are formed in a pin-like shape and adapted to support the rear surface Pb of the substrate P at their top parts. The protruding portions 4 are uniformly provided in plural numbers on the upper surface 3 of the base member 2. The upper surface 3 of the base member 2 has a size and shape corresponding to the substrate P. The upper surface 3 of the base member 2 faces the rear surface Pb of the substrate P when the rear surface Pb of the substrate P is supported on the top parts of the protruding portions 4.

The holder mechanism 10 forms a specified space 8 on the side of the rear surface Pb of the substrate P by allowing the protruding portions 4 to support the rear surface Pb of the substrate P. The specified space 8 includes a space left between the rear surface Pb of the substrate P and the upper surface 3 of the base member 2. The protruding portions 4 provided on the upper surface 3 of the base member 2 create a gap G1 between the rear surface Pb of the substrate P and the upper surface 3 of the base member 2 by supporting the rear surface Pb of the substrate P. The gap G1 has a size decided by the height of the protruding portions 4 and may be set to be ranging from about 10µm to 1mm. In the present embodiment, the gap G1 (the height of the protruding portions 4) is set at about 50µm.

As illustrated in FIG. 3, the gap G1 is substantially uniformly formed over the entire region of the rear surface Pb of the substrate P, even between an edge region Eb of the rear surface Pb of the substrate P and an edge region of the upper surface 3 of the base member 2. And, a gas is allowed to flow (enter and leave) between the specified space 8 and an external space (atmospheric space) 500 lying outside the specified space 8. That is to say, the specified space 8 and the atmospheric space 500 lying outside the specified space 8 are adapted to communicate with each other through the gap G1 between the edge region Eb of the rear surface Pb of the substrate P and the upper surface 3 of the base member 2. The specified space 8 remains opened to the atmosphere. In the following description, the gap between the edge region Eb of the rear surface Pb of the substrate P and the upper surface 3 of the base member 2 will be arbitrarily referred to as an "edge flow path 9".

As shown in FIG. 2B, there is only one suction port 5 formed at around a center portion of the upper surface 3 of the base member 2. The holder mechanism 10 of the liquid removing apparatus 1 holds the substrate P such that the center portion of the upper surface 3 of the base member 2 can face a center portion of the rear surface Pb of the substrate P. In other words, the holder mechanism 10 holds the substrate P so that the suction port 5 can face the center portion of the rear surface Pb of the substrate P. That is to say, the suction port 5 is provided in a region on the upper surface 3 of the base member 2 that faces the center portion of the rear surface Pb of the substrate P held on the holder mechanism 10. Furthermore, the specified space 8 includes a space between the rear surface Pb of the substrate P, which is held by the holder mechanism 10 including the protruding portions 4, and the upper surface 3 of the base member 2. The suction port 5 provided on the upper surface 3 of the base member 2 is connected to the specified space 8.

The evacuation device 7 includes a vacuum system such as a vacuum pump and is capable of sucking up the gas (and the liquid) present in the specified space 8 through the flow path 6 and the suction port 5. The flow path 6 includes an internal flow path 6A formed within the base member 2 so that it can be connected to the suction port 5 and a flow path of a pipe member for interconnecting the internal flow path 6A and the evacuation device 7. As the gas in the specified space 8 is sucked up by the evacuation device 7 through the suction port 5, the gas in the specified space 8 is discharged to the outside. In the present embodiment, the evacuation device 7 draws the gas from the specified space 8 through the suction port 5 at a flow rate ranging from about 1 to 100 liter per minute.

In the present embodiment, the base member 2 and the protruding portions 4 are made of, e.g., ceramics. By subjecting the upper surface 3 of the base member 2 to, e.g., blasting, it is possible to form the protruding portions 4 with a height ranging from about 10µm to 1 mm on the base member 2. Furthermore, the base member 2 and the protruding portions 4 may be made of metal such as stainless steel. Moreover, the upper surface 3 of the base member 2 and the surfaces of the protruding portions 4 are coated with, e.g., a liquid repellent material such as a fluorine-based material and an acrylic material, which means that the upper surface 3 of the base member 2 and the surfaces of the protruding portions 4 exhibit repellency against the liquid LQ. Examples of the liquid repellent material include polytetrafluoroethylene (PTFE), tertafluoroethylene-perfluoroalkoxyethylene copolymer (PFA) and Polyetheretherketone (PEEK). In addition, the base member 2 and the protruding portions 4 themselves may be made of the liquid repellent materials noted just above.

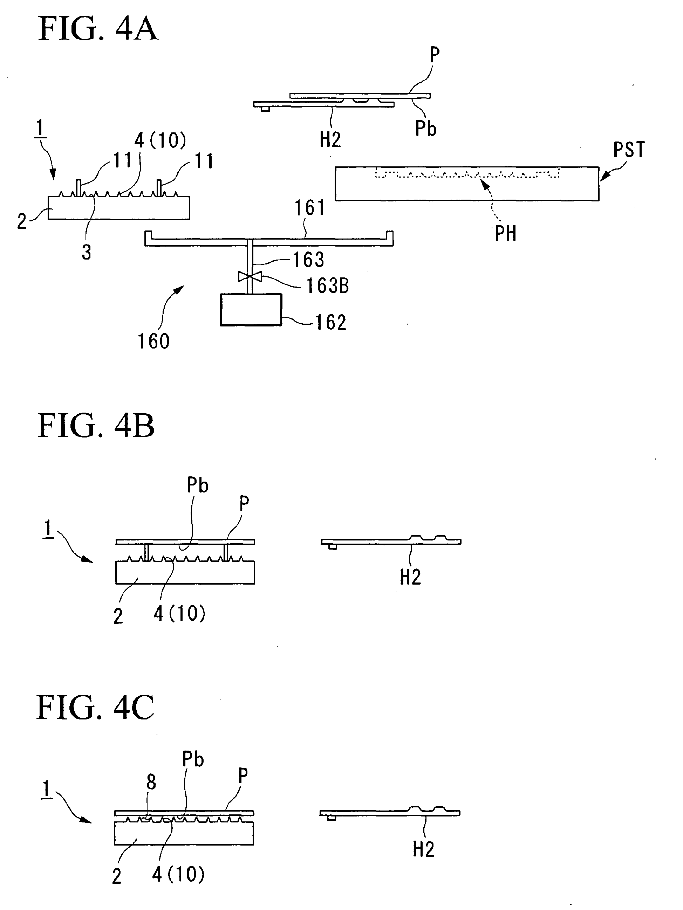

Next, the liquid removing operation performed by the liquid removing apparatus 1 will be described with reference to FIG. 3 and the pattern diagrams shown in FIGS. 4A to 4C.

As illustrated in FIG. 4A, the control unit CONT takes out the substrate P, which has been subjected to a liquid exposure treatment, from the substrate holder PH by use of the second conveyor system H2 and then conveys it to the liquid removing apparatus 1.

As can be seen in FIG. 4A, the liquid removing apparatus 1 is provided with liftable pin members 11 provided on the base member 2. The control unit CONT raises the top end portions of the pin members 11 higher than the top surfaces of the protruding portions 4 when the substrate P is put into the liquid removing apparatus 1 by use of the second conveyor system H2. In this state, the control unit CONT allows the substrate P to be transferred from the second conveyor system H2 onto the pin members 11. By doing so, the rear surface Pb of the substrate P is supported by the pin members 11 as illustrated in FIG. 4A. The control unit CONT makes the second conveyor system H2 be retracted from the liquid removing apparatus 1 and then lowers the pin members 11 on which the rear surface Pb of the substrate P is supported. This ensures that the rear surface Pb of the substrate P is supported by the protruding portions 4 of the liquid removing apparatus 1 as illustrated in FIG. 4C.

The liquid removing apparatus 1 forms the specified space 8 on the side of the rear surface Pb of the substrate P by allowing the substrate P to be held by the holder mechanism 10 including the protruding portions 4. Once the specified space 8 is formed on the side of the rear surface Pb of the substrate P, the control unit CONT operates the evacuation device 7 including a vacuum system to suck up the gas in the specified space 8 through the flow path 6 and the suction port 5. By operating the evacuation device 7, the control unit CONT performs evacuation of the gas from the suction port 5 connected to the specified space 8.

By performing the evacuation of the gas from the suction port 5, the liquid removing apparatus 1 can generate a gas stream moving toward the suction port 5 in the specified space 8. In other words, if the evacuation device 7 is in operation, the gas present around the suction port 5 (i.e., the gas in the specified space 8) is sucked up into the suction port 5. This allows the gas in the atmosphere space 500 to flow into the specified space 8 through the edge flow path 9 as illustrated in FIG. 3, thus generating the gas stream moving toward the suction port 5 in the specified space 8 (see arrow y1 in FIG. 3). At this time, the gas moving toward the suction port 5 flows along the rear surface Pb of the substrate P and the upper surface 3 of the base member 2. That is to say, there is generated in the specified space 8 a gas stream moving toward the suction port 5 guided along the rear surface Pb of the substrate P and the upper surface 3 of the base member 2. In this case, the speed of the gas stream moving toward the suction port 5 is extremely high due to the fact that the gap G1 between the rear surface Pb of the substrate P and the upper surface 3 of the base member 2 is very small, e.g., as small as about 50µm.

The liquid LQ adhered to the rear surface Pb of the substrate P is moved to the suction port 5 by the gas stream moving toward the suction port 5 (see arrow y2 in FIG. 3). Then, the liquid LQ moved to the suction port 5 is recovered the evacuation device 7 through the suction port 5. There is a possibility that the liquid LQ falling from the rear surface Pb of the substrate P adheres to the upper surface 3 of the base member 2. However, the liquid LQ adhered to the upper surface 3 of the base member 2 is also moved to the suction port 5 by virtue of the gas stream moving toward the suction port 5 to be recovered by the evacuation device 7. In the manner described above, the liquid removing apparatus 1 can remove the liquid LQ adhered to the rear surface Pb of the substrate P.

After the liquid removing treatment for the substrate P has been completed by the liquid removing apparatus 1, the control unit CONT raises the pin members 11 to thereby release the holder mechanism 10 of the liquid removing apparatus 1 from holding the substrate P. Then, the control unit CONT allows the third conveyor system H3 to convey the liquid LQ-removed substrate P to the interface part IF. The substrate P conveyed to the interface part IF is transported to the developing unit of the coater/developer main body C/D to be subjected to a developing treatment.

Removal of the liquid LQ adhered to the rear surface Pb of the substrate P by use of the liquid removing apparatus 1 helps to prevent the liquid LQ from disadvantageously splashing into the conveying route of the conveyor system H. If the liquid LQ is splashed into conveying route of the conveyor system H, the internal environment (humidity, cleanliness, etc.) of the first chamber apparatus CH1 could be changed, thus possibly deteriorating exposure accuracy and various kinds of measuring accuracy. However, such deterioration can be avoided by removing the liquid LQ adhered to the rear surface Pb of the substrate P by use of the liquid removing apparatus 1. Furthermore, if the liquid LQ is left adhered to the rear surface Pb of the substrate P, there is a possibility that the liquid LQ becomes adhered to the conveyor system for sustaining the rear surface Pb of the substrate P. If the substrate P is held by the conveyor system to which the liquid LQ is attached, before it being loaded onto the substrate holder PH (namely, prior to the exposure treatment) or being conveyed to the developing unit (namely, prior to the developing treatment), there is a possibility that the liquid LQ of the conveyor system is stuck to the substrate P, thereby making it impossible to efficiently conduct the exposure treatment or the developing treatment. However, such possibility can be prevented by removing the liquid LQ adhered to the substrate P by means of the liquid removing apparatus 1 as in the present embodiment.

Furthermore, in the present embodiment, the substrate P to which the liquid LQ may possibly be adhered is conveyed by the second conveyor system H2 and not by the first conveyor system H1. That is to say, since the liquid LQ is kept from being adhered to the first conveyor system H1, it is possible to prevent the liquid LQ either from being transferred from the first conveyor system H1 to the substrate P which is not yet subjected to the exposure treatment (namely, not yet loaded onto the substrate holder PH), or from being splashed into the conveying route of the first conveyor system H1. Moreover, seeing that the third conveyor system H3 conveys the substrate P which is not yet subjected to the exposure treatment (namely, not yet loaded onto the substrate holder PH) as well as the substrate P for which the liquid removing treatment has been performed by the liquid removing apparatus 1, the liquid LQ is also prevented from being adhered to the third conveyor system H3. Accordingly, the liquid LQ is kept either from being adhered to the rear surface Pb of the substrate P conveyed by the third conveyor system H3 or from being splashed into the conveying route of the third conveyor system H3.

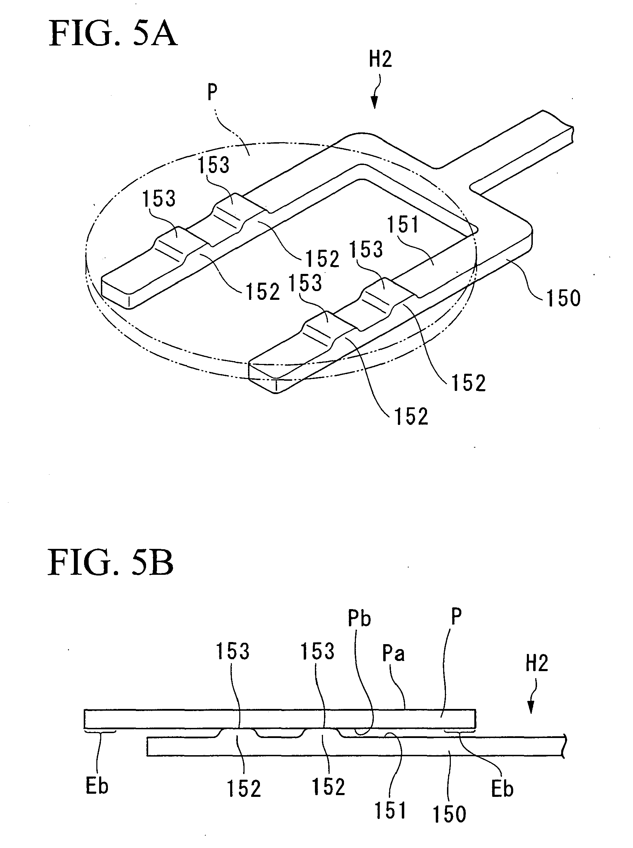

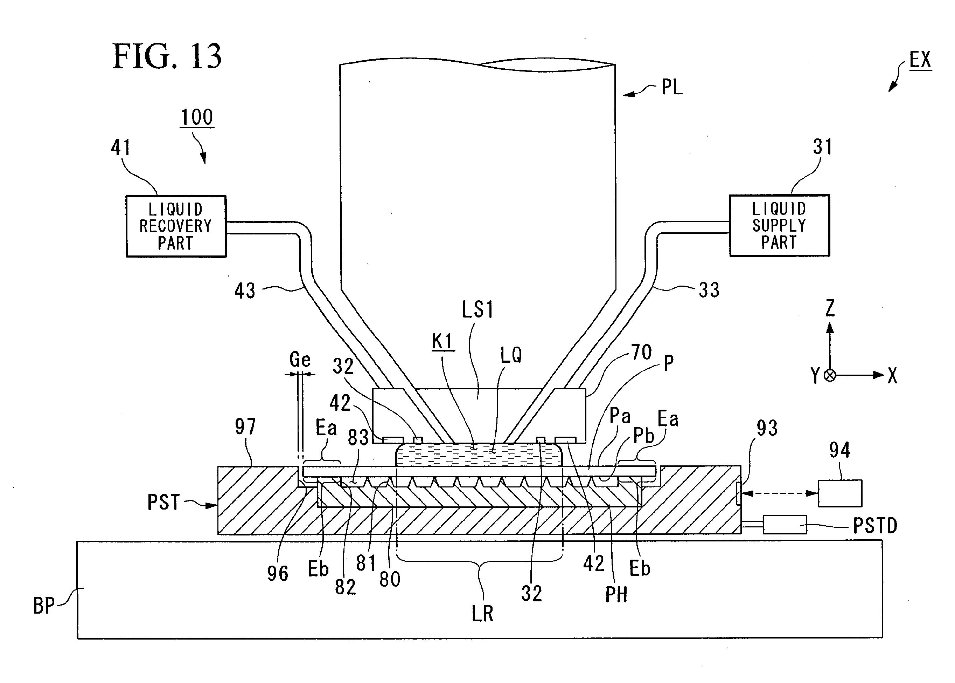

FIG. 5A is a perspective view showing the second conveyor system H2 for holding the substrate P and FIG. 5B is a side view thereof. As illustrated in FIGS. 5A and 5B, the second conveyor system H2 is provided with a conveyor arm 150 having two fork portions. On an upper surface 151 of the conveyor arm 150, there are provided four protruding portions 152 in an island-like shape. And, the second conveyor system H2 holds a generally central region of the rear surface Pb of the substrate P at top surfaces 153 of the protruding portions 152. In other words, the top surfaces 153 of the protruding portions 152 serve as holding surfaces for holding the rear surface Pb of the substrate P. In case the substrate P is supplied with the liquid LQ and subjected to the liquid immersion treatment or process in a state that the substrate P is held on the substrate holder PH, the liquid LQ thus supplied may possibly go to the rear surface Pb of the substrate P through a gap Ge (see FIG. 13) between the front surface Pa of the substrate P and the upper surface 97 of the substrate stage PST. If such is the case, the liquid LQ is highly likely to be adhered to the edge region Eb of the rear surface Pb of the substrate P. The holding surfaces (top surfaces) 153 of the bulged portions 152 of the second conveyor system H2 hold the generally central region of the rear surface Pb of the substrate P and, therefore, do not make contact with the edge region Eb of the rear surface Pb of the substrate P. This prevents the liquid LQ from being adhered to the second conveyor system H2. Likewise, the first and third conveyor systems H1 and H3 may also be designed to hold the generally central region of the rear surface Pb of the substrate P.

Furthermore, as illustrated in FIGS. 1 and 4A, a liquid treating mechanism 160 for treating the liquid LQ falling from the substrate P that has been subjected to the exposure treatment is provided on the conveying route of the second conveyor system H2. The liquid treating mechanism 160 includes a gutter member 161 arranged below the conveying route of the second conveyor system H2 and a liquid suction device 162 for discharging the liquid LQ collected in the gutter member 161. The gutter member 161 is provided between the substrate holder PH and the liquid removing apparatus 1, namely, below the conveying route of the second conveyor system H2. The gutter member 161 is provided inside the first chamber apparatus CH1, whereas the liquid suction device 162 is provided outside the first chamber apparatus CH1. The gutter member 161 and the liquid suction device 162 are connected to each other by way of a pipeline 163, and a valve 163B for closing and opening a flow path of the pipeline 163 is provided on the pipeline 163.

Although the liquid LQ may possibly fall from the substrate P during the course of conveying the liquid-adhered substrate P by the second conveyor system H2, the liquid treating mechanism 160 can collect the falling liquid LQ by using the gutter member 161. By collecting the falling liquid LQ by use of the gutter member 161, it is possible for the liquid treating mechanism 160 to avoid disadvantages such as splash of the liquid LQ to around the conveying route. Due to the fact that the liquid suction device 162 sucks up the liquid LQ in the gutter member 161 provided inside the first chamber apparatus CH1 and discharges the liquid LQ falling into the gutter member 161 to the outside of the first chamber apparatus CH1, the liquid LQ does not stagnate in the gutter member 161 provided inside the first chamber apparatus CH 1. Therefore, the liquid treating mechanism 160 can prevent disadvantages such as occurrence of a change in the internal environment (humidity, cleanliness, etc.) of the first chamber apparatus CH 1.

Furthermore, the liquid treating mechanism 160 may be omitted in case the liquid LQ is less likely to fall from the substrate P.

As described above, the liquid LQ adhered to the rear surface Pb of the substrate P can be removed with a simple construction in which the specified space 8 is formed on the side of the rear surface Pb of the substrate P and the gas in the specified space 8 is evacuated through the suction port 5 provided on the side of the rear surface Pb of the substrate P.

Furthermore, in the present embodiment, the specified space 8 (gap G1) having a fine size ranging from about 10µm to 1mm is formed on the side of the rear surface Pb of the substrate P, and the gas is evacuated through the suction port 5 provided in the fine-sized specified space 8. Thus, a gas stream of high flow velocity is generated on the side of the rear surface Pb of the substrate P, which makes it possible to bring the liquid LQ adhered to the rear surface Pb of the substrate P up to the suction port 5 and to recover the same from the suction port 5. Moreover, owing to the fact that the specified space 8 (gap G1) is fine-sized, it is possible to sufficiently increase the flow velocity of the gas stream generated in the specified space 8 between the rear surface Pb of the substrate P and the upper surface 3 of the base member 2, even if the evacuation quantity per unit time of the gas through the suction port 5 is small, namely, even if the evacuation device 7 has a small suction power. Accordingly, the liquid removing apparatus 1 can recover the liquid LQ adhered to the rear surface Pb of the substrate P by smoothly moving the liquid LQ up to the suction port 5 within a shortened period of time by use of the gas stream of high flow velocity.

Furthermore, since the specified space 8 is opened to the atmosphere through the edge flow path 9, a gas is introduced into the specified space 8 from the outside through the edge flow path 9 even if the gas in the specified space 8 has been evacuated through the suction port 5, thereby making it possible to efficiently generate a desired gas stream.

In addition, since the suction port 5 formed on the upper surface 3 of the base member 2 faces nearly the center of the rear surface Pb of the substrate P, a gas can be introduced into the specified space 8 from the atmospheric space 500 through the entire extent of the edge flow path 9 at a substantially equal flow velocity. This makes it possible to recover the liquid LQ within a shortened period of time even though the liquid LQ is adhered to the whole region of the rear surface Pb of the substrate P. Moreover, in the present embodiment, owing to the fact that there is provided only one suction port 5 at a location to face nearly the center of the rear surface Pb of the substrate P, a gas stream of high flow velocity moving from the edge region of the substrate P toward the center thereof is generated without causing any unevenness in the gas stream moving toward the suction port 5 (in terms of a flow velocity distribution, etc.). This ensures that the evacuation of the gas through the suction port 5 can efficiently contribute for removing the liquid LQ. Therefore, it is possible to reliably remove the liquid LQ adhered to the rear surface Pb of the substrate P, regardless of the position of adherence of the liquid LQ in the rear surface Pb of the substrate P.

Furthermore, by allowing the plurality of pin-like protruding portions 4 to support the rear surface Pb of the substrate P, the specified space 8 is formed on the side of the rear surface Pb of the substrate P without any flexural deformation of the substrate P. Thus, the gas can flow through the spaces between the protruding portions 4, thereby making it possible to efficiently generate a gas stream moving toward the suction port 5 from the edge flow path 9. Moreover, by allowing the plurality of pin-like protruding portions 4 to support the rear surface Pb of the substrate P, it is possible to reduce the contact area of the rear surface Pb of the substrate P with the holder mechanism 10 including the protruding portions 4. This makes it possible to reliably remove the liquid LQ adhered to the rear surface Pb of the substrate P, even if the liquid LQ makes contact with the pin-like protruding portions 4.

### <Second Embodiment of Liquid Removing Apparatus>

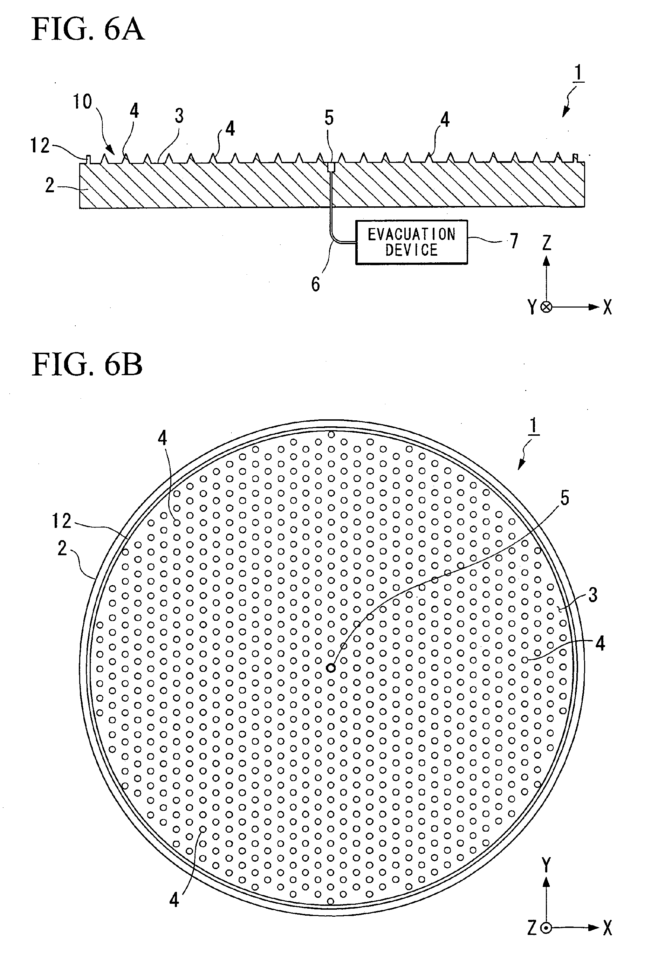

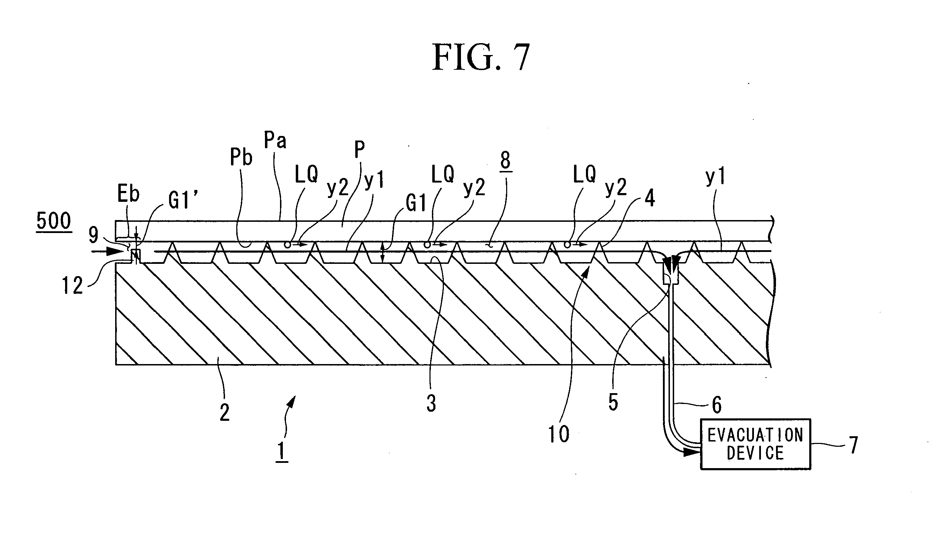

Next, a second embodiment of the liquid removing apparatus 1 will be described with reference to FIGS. 6A, 6B and 7. In the following description, the parts identical with or equivalent to those of the foregoing embodiment will be designated by like reference numerals, and description thereof will be simplified or omitted.

FIG. 6A is a sectional side view illustrating the second embodiment of the liquid removing apparatus 1 and FIG. 6B is a top plan view thereof. FIG. 7 is an enlarged sectional side view depicting major parts of the liquid removing apparatus 1 in which the substrate P is held by the holder mechanism 10.

Referring to FIGS. 6A, 6B and 7, the liquid removing apparatus 1 includes a peripheral wall portion 12 provided on the upper surface 3 of the base member 2 so as to enclose or surround the plurality of pin-like protruding portions 4. Corresponding to the shape of the substrate P, the peripheral wall portion 12 is formed into a generally annular shape when seen from the top. The peripheral wall portion 12 has a top surface provided so as to face the edge region Eb of the rear surface Pb of the substrate P held on the holder mechanism 10. Furthermore, the peripheral wall portion 12 is formed in a smaller height than the protruding portions 4. That is to say, as shown in FIG. 7, a prescribed gap G1' is formed between the rear surface Pb of the substrate P and the top surface of the peripheral wall portion 12 when the rear surface Pb of the substrate P is held by the holder mechanism 10 including the protruding portions 4. A specified space 8 enclosed by the upper surface 3 of the base member 2, the peripheral wall portion 12 and the rear surface Pb of the substrate P is formed on the side of the rear surface Pb of the substrate P held on the holder mechanism 10. The gap G1' is smaller than the gap G1 formed between the rear surface Pb of the substrate P and the upper surface 3 of the base member 2. In the present embodiment, the edge flow path 9 is formed by the gap G1' between the edge region Eb of the rear surface Pb of the substrate P and the top surface of the peripheral wall portion 12. The specified space 8 communicates with the atmospheric space 500 through the gap G1', which means that the specified space 8 is opened to the atmosphere. In addition, as in the foregoing embodiment, a suction port 5 is provided on the upper surface 3 of the base member 2.

In this way, by providing the peripheral wall portion 12 having the top surface that faces the rear surface Pb of the substrate P, it becomes possible to further increase the flow velocity of a gas stream generated near the edge region Eb of the rear surface Pb of the substrate P. In the event that a liquid immersion treatment is performed by supplying the liquid LQ to the substrate P while the substrate P is held on the substrate holder PH, the liquid LQ is highly likely to be adhered to the edge region Eb of the rear surface Pb of the substrate P. For this reason, by providing the peripheral wall portion 12, the flow velocity of the gas stream generated near the edge region Eb of the rear surface Pb of the substrate P (namely, near the gap G1') is increased to thereby ensure that the liquid LQ adhered to the edge region of the rear surface Pb of the substrate P can be more smoothly move to the suction port 5.

### <Third Embodiment of Liquid Removing Apparatus>

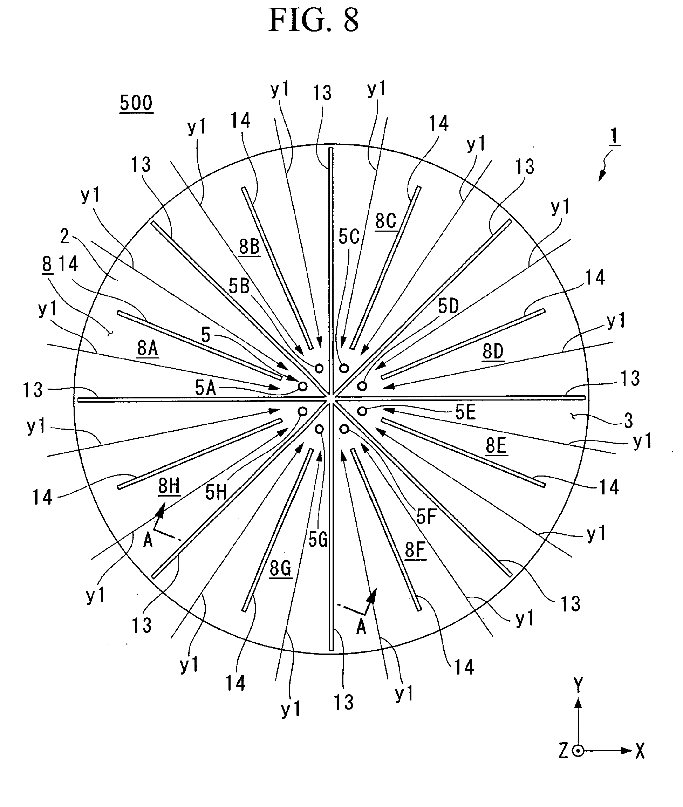

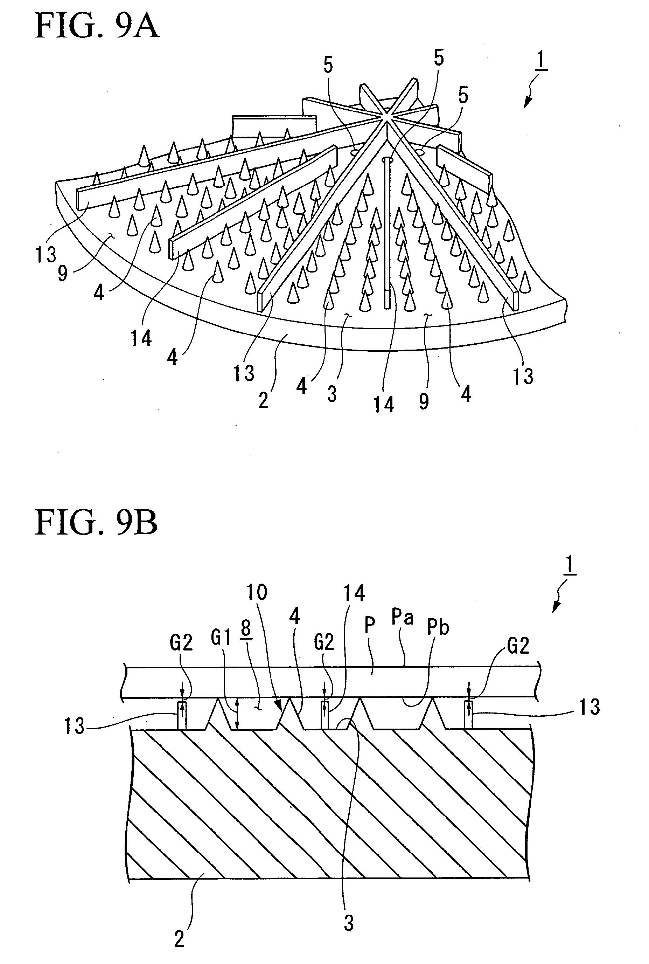

Next, a third embodiment of the liquid removing apparatus 1 will be described with reference to FIGS. 8, 9A and 9B. FIG. 8 is a top plan view illustrating the liquid removing apparatus 1 in accordance with the third embodiment. Furthermore, FIG. 9A is an enlarged perspective view depicting major parts of the liquid removing apparatus 1 and FIG. 9B is an enlarged sectional side view (a section view taken along arrow line A-A in FIG. 8) depicting major parts of the liquid removing apparatus 1 in which the substrate P is held by the holder mechanism 10.

Referring to FIGS. 8, 9B and 9B, the liquid removing apparatus 1 includes first guide members 13 for guiding a gas stream generated in the specified space 8. The first guide members 13 serve to guide the gas stream moving toward suction ports 5 (5A-5H) and are arranged on the upper surface 3 of the base member 2. Furthermore, just like the foregoing embodiments, pin-like protruding portions 4 for supporting the rear surface Pb of the substrate P are provided in plural numbers in other regions on the upper surface 3 of the base member 2 than the regions in which the first guide members 13 are formed. The protruding portions 4 are not illustrated in FIG. 8 for the purpose of making the drawings look simpler and more understandable. The first guide members 13 are adapted to face the rear surface Pb of the substrate P when the rear surface Pb of the substrate P is held by the holder mechanism 10 including the protruding portions 4.

As shown in FIG. 8, the first guide members 13 are formed in plural numbers to radially extend from a generally central portion of the upper surface 3 of the base member 2 when seen from the top. The holder mechanism 10 holds the substrate P in such a way that the center portion of the upper surface 3 of the base member 2 and that of the rear surface Pb of the substrate P are made to face with each other. The specified space 8 is divided into a plurality of partition spaces by the first guide members 13. In the present embodiment, the specified space 8 is divided into eight mutually-adjoining partition spaces 8A to 8H. As set forth above, the first guide members 13 of the present embodiment are formed in a radial pattern and the respective partition spaces 8A to 8H are formed in a sectorial shape so that they can gradually converge on the center portion of the rear surface Pb of the substrate P from the edge region Eb of the latter. Furthermore, the plurality of first guide members 13 are radially arranged at an equal angular interval, which means that the respective partition spaces 8A to 8H are nearly identical in size and shape with one another.

Furthermore, the suction ports 5 are connected to the partition spaces 8A to 8H in a one-to-one correspondence. In the present embodiment, eight suction ports 5A to 5H are provided near the center of the upper surface 3 of the base member 2 in a corresponding relationship with the eight partition spaces 8A to 8H. Moreover, the suction ports 5A to 5H are nearly identical in size and shape with one another. As in the first and second embodiments described above, the respective suction ports 5A to 5H are connected to the evacuation device 7. In the present embodiment, the plurality of radially-formed first guide members 13 serve to guide gas streams moving toward the suction ports 5A to 5H.

Just like the first embodiment set forth above, by allowing the protruding portions 4 provided on the upper surface 3 of the base member 2 to support the rear surface Pb of the substrate P, a gap G1 is formed between the rear surface Pb of the substrate P and the upper surface 3 of the base member 2. The gap G1 is also formed between the edge region Eb of the rear surface Pb of the substrate P and the edge region of the upper surface 3 of the base member 2, thereby allowing a gas to flow (enter and leave) between the partition spaces 8A to 8H and the atmospheric space 500 lying outside the partition spaces 8A to 8H. That is to say, near the edge region Eb of rear surface Pb of the substrate P, there are provided edge flow paths 9 through which the respective partition spaces 8A to 8H communicate with the atmospheric space 500 lying outside the partition spaces 8A to 8H. The edge flow paths 9 are formed in a one-to-one correspondence with the respective partition spaces 8A to 8H. In the meantime, the suction ports 5A to 5H are provided so as to face a near-center region of the rear surface Pb of the substrate P held on the holder mechanism 10. In other words, the respective suction ports 5A to 5H are provided in proximity to the apexes of the sector-like partition spaces 8A to 8H. Further, the positional relationships between the partition spaces 8A to 8H and the respective suction ports 5A to 5H corresponding to the partition spaces 8A to 8H are substantially the same.

Second guide members 14 for guiding gas streams generated in the respective partition spaces 8A to 8H are provided in the respective partition spaces 8A to 8H. As with the first guide members 13, the second guide members 14 serve to guide the gas streams moving toward the respective suction ports 5A to 5H and are provided in plural numbers on the upper surface 3 of the base member 2 in a corresponding relationship with the plurality of partition spaces 8A to 8H. In the present embodiment, the second guide members 14 are provided in a one-to-one correspondence with the partition spaces 8A to 8H. Each of the second guide members 14 is arranged to radially extend from the center portion of the upper surface 3 of the base member 2. In other words, each of the second guide members 14 is provided in such a way that it radially extends from the center portion of the rear surface Pb of the substrate P held by the holder mechanism 10 toward the edge region Eb of the latter. Each of the second guide members 14 is provided in a generally medial portion in a θZ direction of each of the sector-like partition spaces 8A to 8H, and each of the suction ports 5A to 5H is arranged on a longitudinal extension line of a corresponding one of the second guide members 14 when seen from the top. The positional relationships between the respective partition spaces 8A to 8H (suction ports 5A to 5H) and the respective second guide members 14 corresponding to the partition spaces 8A to 8H (suction ports 5A to 5H) are substantially the same. The second guide members 14 are adapted to face the rear surface Pb of the substrate P when the rear surface Pb of the substrate P is held by the holder mechanism 10 including the protruding portions 4.

The first and second guide members 13 and 14 are provided in a smaller height than the protruding portions 4. In other words, as illustrated in FIG. 9B, a prescribed gap G2 is created between the top surfaces of the first and second guide members 13 and 14 and the rear surface Pb of the substrate P when the rear surface Pb of the substrate P is held by the holder mechanism 10 including the protruding portions 4. The gap G2 has a size decided by the height of the first and second guide members 13 and 14 and is smaller in size than the gap G1. In the present embodiment, the gap G2 is set to be ranging from about 2µm to 5µm.

Next, description will be made on the liquid removing operation performed by the liquid removing apparatus 1 of the third embodiment. If the evacuation device 7 is operated with the substrate P held by the holder mechanism 10, the gas from the atmospheric space 500 is introduced into the partition spaces 8A to 8H through the edge flow paths 9, as indicated by arrow y1 in FIG. 8, and gas streams moving toward the respective suction ports 5A to 5H are generated in the respective partition spaces 8A to 8H. The gas streams moving toward the respective suction ports 5A to 5H flow under the guidance of the rear surface Pb of the substrate P and the upper surface 3 of the base member 2 and also under the guidance of the first and second guide members 13 and 14. The liquid LQ adhered to the rear surface Pb of the substrate P is moved to the suction ports 5A to 5H by means of the gas streams moving toward the suction ports 5A to 5H, wherein gas streams are generated by performing evacuation from the suction ports 5A to 5H. The liquid LQ moved to the suction ports 5A to 5H is recovered by the evacuation device 7 through the suction ports 5A to 5H. In the way noted above, the liquid removing apparatus 1 can remove the liquid LQ adhered to the rear surface Pb of the substrate P.

As described above, provision of the guide members 13 and 14 makes it possible to guide the gas streams that are introduced into the specified space 8 (partition spaces 8A to 8H) from the atmospheric space 500 through the edge flow paths 9 and moved toward the suction ports 5A to 5H. Therefore, it is possible to generate gas streams of reduced turbulence and increased flow velocity in the respective partition spaces 8A to 8H, which in turn assures better removal of the liquid LQ adhered to the rear surface Pb of the substrate P.

Furthermore, by dividing the specified space 8 into the plurality of partition spaces 8A to 8H by use of the first guide members 13 and providing the plurality of suction ports 5A to 5H in a corresponding relationship with the plurality of partition spaces 8A to 8H, gas streams having a velocity great enough to move the liquid LQ adhered to the rear surface Pb of the substrate P can be easily obtained in the respective partition spaces 8A to 8H without causing any unevenness in the gas streams moving toward the respective suction ports 5A to 5H (in terms of a flow velocity distribution, etc.).

Furthermore, the gap G2 is formed between the top surfaces of the first and second guide members 13 and 14 and the rear surface Pb of the substrate P held on the holder mechanism 10, and the rear surface Pb of the substrate P does not make contact with the first and second guide members 13 and 14. This helps to prevent contamination of the substrate P which would otherwise be caused by the contact of the rear surface Pb of the substrate P with the first and second guide members 13 and 14. In this regard, the gap G2 has a fine size ranging from about 2µm to 5µm, which results in an increased gas flow resistance in the gap G2. Accordingly, the gas streams moving toward the suction ports 5A to 5H along the first and second guide members 13 and 14 can be generated in a smooth manner.

In the present embodiment, the respective partition spaces 8A to 8H are formed by the first guide members 13 into a sectorial shape when seen from the top, and the suction ports 5 are provided on the upper surface 3 of the base member 2 so as to face the generally central portion of the rear surface Pb of the substrate P. This ensures that the gas introduced into the respective partition spaces 8A to 8H from the atmospheric space 500 through the edge flow paths 9 can flow up to the suction ports 5A to 5H at an increased velocity.

Furthermore, by providing the second guide members 14 in the generally central portion in a θZ direction of each of the sector-like partition spaces 8A to 8H and disposing each of the suction ports 5A to 5H on the longitudinal extension line of the corresponding second guide member 14 when seen from the top, it is possible to more reliably generate the gas streams moving toward the respective suction ports 5A to 5H. This enables the liquid LQ adhered to the rear surface Pb of the substrate P to be moved to suction ports 5A to 5H in a surer manner. Moreover, the second guide members 14 may be provided in plural numbers in each of the partition spaces 8A to 8H, and the second guide members 14 may be omitted if the desired gas streams can be obtained without the second guide members 14.

Although eight first guide members 13 are arranged to form the eight partition spaces 8A to 8H in the present embodiment, the number of the first guide members 13 may be arbitrarily determined depending on circumstances.

Furthermore, in the present embodiment, the size and shape of the partition spaces 8A to 8H, the size and shape of the suction ports 5A to 5H and the evacuation quantity per unit time of the gas through the suction ports 5A to 5H are set in such a way that the gas has a generally equal flow velocity in the respective partition spaces 8A to 8H. That is to say, in order to assure a generally equal gas flow velocity in the respective partition spaces 8A to 8H, substantially equally set are the size and shape of the respective partition spaces 8A to 8H, the size and shape of the respective suction ports 5A to 5H, the positional relationship between the partition spaces 8A to 8H and the respective suction ports 5A to 5H provided in a corresponding relationship with the partition spaces 8A to 8H, and the evacuation quantity per unit time of the gas through the suction ports 5A to 5H. By doing so, it becomes possible to generally equalize the capacity of removing the liquid LQ in the respective partition spaces 8A to 8H. Alternatively, the gas may be allowed to have different flow velocities in the respective partition spaces 8A to 8H. As an example, the evacuation quantities per unit time of the gas through the respective suction ports 5A to 5H may be made different. In this case, the evacuation quantities per unit time of the gas through the respective suction ports 5A to 5H can be made different by, e.g., connecting mutually independent evacuation devices 7 to the respective suction ports 5A to 5H and differently setting the evacuation quantities per unit time of the respective evacuation devices 7.

Furthermore, in the present embodiment, the peripheral wall portion 12 is not provided and the gap G1 ranging from 10µm to 1mm is provided between the edge region Eb of the rear surface Pb of the substrate P and the edge region of the upper surface 3 of the base member 2. Instead, as in the second embodiment described above, the peripheral wall portion 12 may be provided so that the prescribed gap G1' can be formed between the rear surface Pb of the substrate P and the top surface of the peripheral wall portion 12. In this case, the peripheral wall portion 12 is provided outside the first and second guide members 13 and 14 so as to enclose first and second guide members 13 and 14.

Furthermore, although the first and second guide members 13 and 14 are substantially identical in height with each other in the present embodiment, they may have different heights. As an example, the top surfaces of the second guide members 14 may be formed in a smaller height than the first guide members 13 so that, when the rear surface Pb of the substrate P is held by the holder mechanism 10, the prescribed gap G2 can be formed between the rear surface Pb of the substrate P and the top surfaces of the first guide members 13 and a gap greater than the gap G2 can be formed between the rear surface Pb of the substrate P and the top surfaces of the second guide members 14.

Furthermore, although the rear surface Pb of the substrate P held by the holder mechanism 10 including the plurality of pin-like protruding portions 4 is spaced apart from the top surfaces of the first and second guide members 13 and 14 in the present embodiment, the rear surface Pb of the substrate P may be brought into contact with at least one of the first and second guide members 13 and 14. Even if the rear surface Pb of the substrate P makes contact with at least one of the first and second guide members 13 and 14, gas streams moving toward the suction ports 5 (5A to 5H) can be generated by performing evacuation of the gas through the suction ports 5 (5A to 5H). In case the rear surface Pb of the substrate P is brought into contact with the top surfaces of the first and second guide members 13 and 14, it becomes possible to eliminate the protruding portions 4 because the rear surface Pb of the substrate P can be supported by the top surfaces of the first and second guide members 13 and 14.

Furthermore, although the plurality of the first guide members 13 are formed so that they can be joined together near the center of the upper surface 3 of the base member 2 in the present embodiment, the first guide members 13 may be formed in such a way that they do not make connection to one another near the center of the upper surface 3 as the second guide members 14 do so. In this case, it may suffice to provide a single suction port 5 near the center of the upper surface 3 of the base member 2, in lieu of the plurality of suction ports 5A to 5H.

Furthermore, in the liquid removing apparatuses of the first through third embodiments, the gas stream(s) moving toward the suction ports 5(5A to 5H) is generated in the specified space 8 by introducing the gas from the edge flow path(s) 9 formed in the edge region of the substrate P held on the holder mechanism 10. Instead, an atmospherically-opened hole communicating with the atmospheric space 500 may be disposed on the upper surface 3 of the base member 2, and the liquid LQ adhered to the rear surface Pb of the substrate P may be removed by a gas stream moving from the atmospherically-opened hole toward the suction port 5.

### <Fourth Embodiment of Liquid Removing Apparatus>

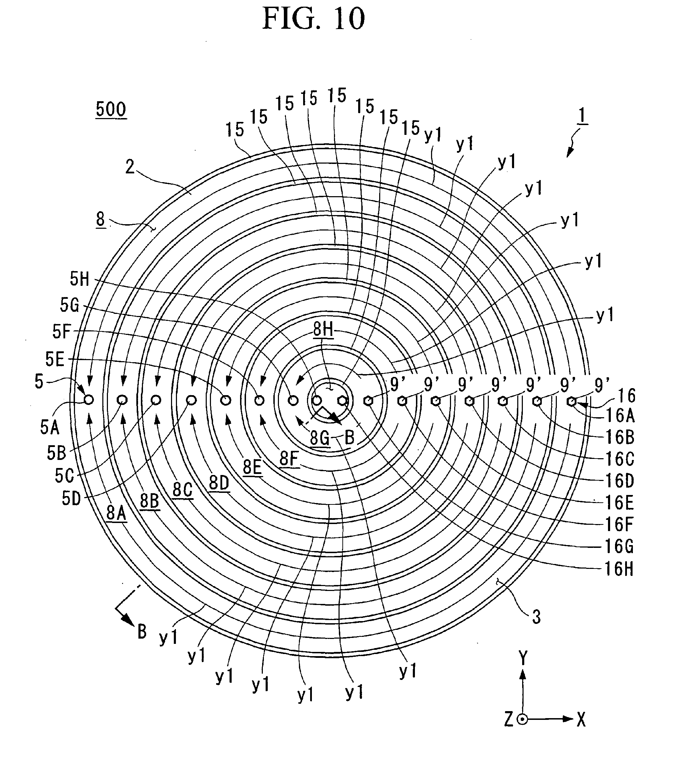

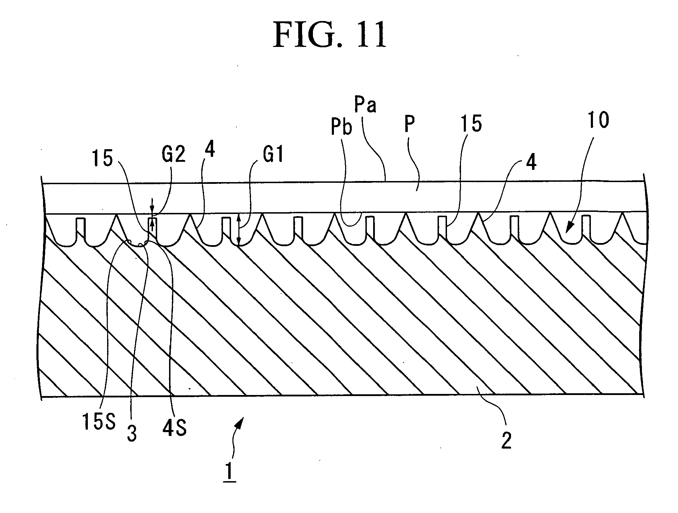

Next, a fourth embodiment of the liquid removing apparatus 1 will be described with reference to FIGS. 10 and 11. FIG. 10 is a top plan view showing the liquid removing apparatus 1 in accordance with the fourth embodiment and FIG. 11 is a section view taken along arrow line B-B in FIG. 10.

Referring to FIGS. 10 and 11, the liquid removing apparatus 1 includes guide members 15 for guiding a gas stream generated in the specified space 8. The guide members 15 serve to guide the gas stream moving toward suction ports 5 and are arranged on the upper surface 3 of the base member 2. Furthermore, just like the foregoing embodiments, pin-like protruding portions 4 for supporting the rear surface Pb of the substrate P are provided in plural numbers in other regions on the upper surface 3 of the base member 2 than the regions in which the guide members 15 are formed. The protruding portions 4 are not illustrated in FIG. 10 for the purpose of making the drawings simpler and more understandable. The guide members 15 are adapted to face the rear surface Pb of the substrate P when the rear surface Pb of the substrate P is held by the holder mechanism 10 including the protruding portions 4.

As shown in FIG. 10, the plurality of guide members 15 are formed in an annular shape and concentrically arranged on the upper surface 3 of the base member 2 when seen from the top. In the present embodiment, each of the plurality of guide members 15 is formed into an annulus shape. The center of each of the plurality of guide members 15 coincides with the center portion of the upper surface 3 of the base member 2. The holder mechanism 10 holds the substrate P so that the center portion of the upper surface 3 of the base member 2 can face the center portion of the rear surface Pb of the substrate P. In other words, the holder mechanism 10 holds the substrate P in such a way that the center portion of the guide members 15 formed in an annular shape and concentrically arranged with one another can face the center portion of the rear surface Pb of the substrate P. And, the specified space 8 is divided into a plurality of (eight) partition spaces 8A to 8H by virtue of the guide members 15. Seeing that the plurality of annular guide members 15 are concentrically arranged with one another, the respective partition spaces 8A to 8H are provided in an annulus shape and formed in a generally concentric pattern.

Suction ports 5 are provided inside the respective partition spaces 8A to 8H. The suction ports 5 are provided in plural numbers in the respective partition spaces 8A to 8H. In the present embodiment, the suction ports 5 are arranged in a one-to-one correspondence with the respective partition spaces 8A to 8H. In the present embodiment, eight suction ports 5A to 5H are provided on the upper surface 3 of the base member 2 in a corresponding relationship with the eight partition spaces 8A to 8H. The respective suction ports 5A to 5H are substantially identical in size and shape with one another. As in the first through third embodiments described above, the respective suction ports 5A to 5H are connected to the evacuation device 7.

The base member 2 of the present embodiment has flow paths 9' through which the specified space 8 communicates with the atmospheric space 500 lying outside the specified space 8. The flow paths 9' are internal flow paths formed within the base member 2 and are provided in plural numbers in a corresponding relationship with the respective partition spaces 8A to 8H. The flow paths 9' are connected at one ends thereof to the respective partition spaces 8A to 8H of the specified space 8 and at the other ends thereof to the atmospheric space 500.

Atmospherically-opened holes 16 formed at the one ends of the flow paths 9' are connected to the respective partition spaces 8A to 8H. The atmospherically-opened holes 16 are provided in plural numbers in a corresponding relationship with the respective partition spaces 8A to 8H. In the present embodiment, the atmospherically-opened holes 16A to 16H are arranged in a one-to-one correspondence with the respective partition spaces 8A to 8H. In the present embodiment, eight atmospherically-opened holes 16A to 16H are provided on the upper surface 3 of the base member 2 in a corresponding relationship with the respective eight partition spaces 8A to 8H. The atmospherically-opened holes 16A to 16H have a prescribed positional relationship with the respective suction ports 5A to 5H. In the present embodiment, the suction ports 5A to 5H are provided on the -X side of the annular partition spaces 8A to 8H and the atmospherically-opened holes 16A to 16H are provided on the +X side thereof. That is to say, the suction ports 5A to 5H and the respective atmospherically-opened holes 16A to 16H are provided in symmetrical positions with respect to the center portion of the upper surface 3 of the base member 2.

As illustrated in FIG. 11, the protruding portions 4 provided on the upper surface 3 of the base member 2 are adapted to support the rear surface Pb of the substrate P, thereby creating a gap G1 between the rear surface Pb of the substrate P and the upper surface 3 of the base member 2.

The guide members 15 are provided in a smaller height than the protruding portions 4. That is to say, as depicted in FIG. 11, a prescribed gap G2 is formed between the top surfaces of the guide members 15 and the rear surface Pb of the substrate P when the rear surface Pb of the substrate P is held by the holder mechanism 10 including the protruding portions 4. The gap G2 has a size decided by the height of the guide members 15 and is set smaller than the gap G1. The gap G2 is set to range from about 2µm to 5µm in the present embodiment.

Furthermore, in the present embodiment, juncture portions 4S of the upper surface 3 of the base member 2 joined to the respective protruding portions 4 and juncture portions 15S of the upper surface 3 of the base member 2 joined to the respective guide members 15 are formed in an arcuate shape when seen in cross section, as can be noted in FIG. 11.

Next, description will be made on the liquid removing operation performed by the liquid removing apparatus 1 of the fourth embodiment. If the evacuation device 7 is operated with the substrate P held by the holder mechanism 10, the gas in the atmospheric space 500 is introduced into the partition spaces 8A to 8H through the flow paths 9' and the atmospherically-opened holes 16A to 16H, as indicated by arrow y1 in FIG. 10, and gas streams moving toward the respective suction ports 5A to 5H are generated in the respective partition spaces 8A to 8H. The gas streams moving toward the respective suction ports 5A to 5H flow under the guidance of the rear surface Pb of the substrate P and the upper surface 3 of the base member 2 and also under the guidance of the guide members 15. The liquid LQ adhered to the rear surface Pb of the substrate P is moved to the suction ports 5A to 5H by means of the gas streams moving toward the suction ports 5A to 5H, wherein the gas streams is generated by performing evacuation through the suction ports 5A to 5H. The liquid LQ moved to the suction ports 5A to 5H is recovered by the evacuation device 7 through the suction ports 5A to 5H. In the way noted above, the liquid removing apparatus 1 can remove the liquid LQ adhered to the rear surface Pb of the substrate P.

As described above, provision of the annular guide members 15 makes it possible to guide the gas streams that are introduced into the specified space 8 (partition spaces 8A to 8H) from the atmospheric space 500 through the atmospherically-opened holes 16 (flow paths 9') and moved toward the suction ports 5A to 5H. Therefore, it is possible to more reliably remove the liquid LQ adhered to the rear surface Pb of the substrate P.

Furthermore, by dividing the specified space 8 into the plurality of partition spaces 8A to 8H by use of the guide members 15 and providing the plurality of suction ports 5A to 5H and the plurality of atmospherically-opened holes 16A to 16H in a corresponding relationship with the plurality of partition spaces 8A to 8H, gas streams having a velocity great enough to move the liquid LQ can be easily obtained in the respective partition spaces 8A to 8H without causing any unevenness in the gas streams moving toward the respective suction ports 5A to 5H (in terms of a flow velocity distribution, etc.).

Furthermore, in the present embodiment, the juncture portions 4S of the upper surface 3 of the base member 2 joined to the respective protruding portions 4 and the juncture portions 15S of the upper surface 3 of the base member 2 joined to the respective guide members 15 are formed in an arcuate shape when seen in cross section, as can be seen in FIG. 11. Thus, even if the liquid LQ adheres to the side surfaces of the protruding portions 4 or the guide members 15, the liquid LQ can be smoothly moved to the suction ports 5A to 5H by the gas streams moving toward the suction ports 5A to 5H without stagnating on the upper surface 3 of the base member 2 or other portions.

Furthermore, it is also true in the present embodiment that the gap G2 is formed between the top surfaces of the guide members 15 and the rear surface Pb of the substrate P held on the holder mechanism 10, and the rear surface Pb of the substrate P does not make contact with the guide members 15. This helps to prevent contamination of the substrate P which would otherwise be caused by the contact of the rear surface Pb of the substrate P with the guide members 15. In this regard, the gap G2 has a fine size ranging from about 2µm to 5µm, which results in an increased gas flow resistance in the gap G2. Accordingly, the gas streams moving toward the suction ports 5A to 5H along the guide members 15 can be generated in a smooth manner.

Furthermore, although the rear surface Pb of the substrate P held by the holder mechanism 10 including the protruding portions 4 is spaced apart from the top surfaces of the guide members 15 in the present embodiment, the rear surface Pb of the substrate P may be brought into contact with at least one of the plurality of guide members 15. Moreover, the protruding portions 4 may be omitted in case the rear surface Pb of the substrate P and the top surfaces of the guide members 15 are kept in contact with each other.

Furthermore, the control unit CONT is able to set the respective evacuation quantities per unit time of the gas through the suction ports 5A to 5H so that the gas flow velocities in the respective partition spaces 8A to 8H can become nearly equal to one another. This makes it possible to substantially equalize the capability of removing the liquid LQ in the respective partition spaces 8A to 8H. As can be seen in FIG. 10, in the present embodiment, the partition space 8A among the plurality of partition spaces 8A to 8H has the largest diameter (size) and the more inwardly the partition spaces 8B to 8H lie, the smaller the diameter (size) thereof becomes. Therefore, the gas stream moving from the atmospherically-opened hole 16A of the partition space 8A toward the suction port 5A shows the greatest flow resistance (pressure loss). In view of this, the control unit CONT adjusts the evacuation capacities (suction power) of the evacuation devices (suction devices) connected to the partition spaces 8A to 8H into different values in accordance with the pressure loss in the partition spaces 8A to 8H, respectively, so that the flow velocities of the gas in the partition spaces 8A to 8H become substantially equal to one another. More specifically, the control unit CONT makes greatest the suction power of the evacuation device connected to the suction port 5A provided in the partition space 8A having the largest diameter, gradually reduces the suction power of the evacuation devices connected to the partition spaces 8B to 8G as the diameters thereof grow smaller, and makes smallest the suction power of the evacuation device connected to the partition space 8H having the smallest diameter.

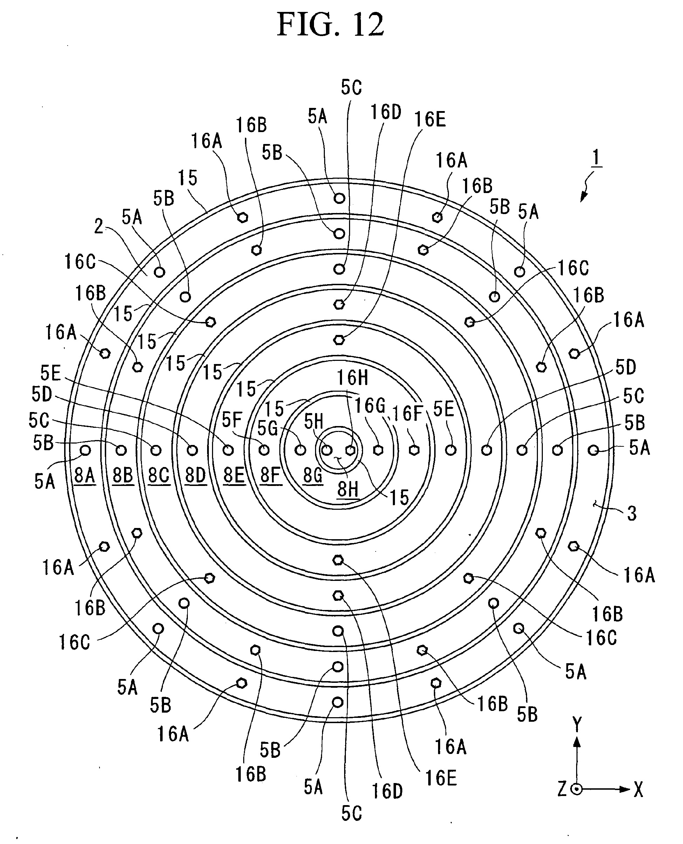

Furthermore, as illustrated in FIG. 12, the number and layout of the suction ports 5A to 5H and the atmospherically-opened holes 16A to 16H provided within the respective partition spaces 8A to 8H may be set to ensure that the flow velocities of the gas in the respective partition spaces 8A to 8H become substantially equal to one another. More specifically, the number and layout of the suction ports 5A to 5H and the atmospherically-opened holes 16A to 16H provided within the partition spaces 8A to 8H is set in accordance with the respective diameters (size) of the partition spaces 8A to 8H. In other words, the number of the suction ports 5A to 5H and the atmospherically-opened holes 16A to 16H are kept high in the partition space 8A having the largest diameter and is reduced in the inwardly-lying partition spaces 8B to 8H. With the example shown in FIG. 12, the suction ports 5A and the atmospherically-opened holes 16A provided in the partition space 8A are eight in number, respectively, and are alternately arranged with one another in the θZ direction. Similarly, the suction ports 5B and the atmospherically-opened holes 16B provided in the partition space 8B are eight in number, respectively, and are alternately arranged with one another. Likewise, four suction ports 5C and four atmospherically-opened holes 16C are alternately arranged with one another in the partition space 8C. Two suction ports 5D and two atmospherically-opened holes 16D are alternately arranged with one another in the partition space 8D, whereas two suction ports 5E and two atmospherically-opened holes 16E are alternately arranged with one another in the partition space 8E. Moreover, a single suction port 5F, 5G or 5H and a single atmospherically-opened hole 16F, 16G or 16H are arranged in each of the partition spaces 8F, 8G and 8H. In this case, it may also be possible to make the evacuation quantities per unit time of the gas from the respective suction ports 5A to 5H differ from one another. This makes it possible to generally equalize the flow velocities of the gas in the respective partition spaces 8A to 8H, whereby the capabilities of removing the liquid LQ in the respective partition spaces 8A to 8H can be made substantially equal. In addition to the above, the juncture portions 4S of the upper surface 3 of the base member 2 joined to the respective protruding portions 4 and the juncture portions 15S of the upper surface 3 of the base member 2 joined to the respective guide members 15 may be formed in a rectilinear (planar) shape when seen in cross section.

Furthermore, in the fourth embodiment, the flow velocities of the gas in the partition spaces 8A to 8H may be set arbitrarily. As an example, the evacuation quantity per unit time of the gas from the suction port 5A and/or the position and number of the suction port 5A and the atmospherically-opened hole 16A may be set so that the flow velocity of the gas can become greatest in the partition space 8A facing the edge region of the rear surface Pb of the substrate P which is susceptible to adherence of the liquid LQ.

Furthermore, in the third and fourth embodiments described above, the guide members and the base member 2 may be integrally formed with each other or separably formed as independent units. Moreover, prior to loading the exposed substrate P onto the base member 2 of the liquid removing apparatus 1, the guide members may be attached to the rear surface Pb of the substrate P, in which state the guide members and the substrate P may be loaded together onto the base member 2.

Furthermore, in the first through fourth embodiments described above, the upper surface 3 of the base member 2 and the surfaces of the protruding portions 4 have liquid repellency with respect to the liquid LQ. However, even if they are not liquid repellent, the liquid LQ can be moved to the suction port 5 by performing the evacuation of the gas from the suction port 5 and consequently generating a gas stream of high flow velocity moving toward the suction port 5.

Furthermore, in the first through fourth embodiments described above, the suction port 5 is provided on the upper surface 3 of the base member 2. Instead, a member having a suction port may be disposed in the specified space 8 independently of the base member 2 and the gas in the specified space 8 may be evacuated through the suction port provided in that member.

Furthermore, in the first through fourth embodiments described above, the holder mechanism 10 for holding the substrate P includes the protruding portions 4 provided on the base member 2, and the specified space 8 is created on the side of the rear surface Pb of the substrate P by having the protruding portions 4 to support the rear surface Pb of the substrate P. Instead, the substrate P may be held by a holder mechanism provided independently of the base member 2, thereby forming the specified space 8 on the side of the rear surface Pb of the substrate P. As an example, the substrate P may be held by a holder mechanism capable of holding a side surface of the substrate P and the upper surface 3 of the base member 2 may be disposed to face the rear surface Pb of the substrate P held by the holder mechanism, thus forming the specified space 8 between the rear surface Pb of the substrate P and the upper surface 3 of the base member 2.

Furthermore, in the first through fourth embodiments described above, the specified space 8 is provided over the nearly entire region of the rear surface Pb of the substrate P. Thus, in case the liquid immersion exposure is performed in a state that the substrate P is held on the substrate holder PH, the liquid LQ is highly likely to adhere to the edge region Eb of the rear surface Pb of the substrate P. In view of this, the specified space 8 for removal of the liquid LQ may be formed only in a region corresponding to the edge region Eb of the rear surface Pb of the substrate P and the suction port 5 may be provided in the specified space 8 thus formed, whereby evacuation of the gas can be conducted through the suction port 5. By doing so, it is possible to remove the liquid LQ adhered to the edge region Eb of the rear surface Pb of the substrate P.

### <Exposure Apparatus Main Body EX>

Referring next to FIGS. 1 and 13, description will be made on a first embodiment of the exposure apparatus main body EX for subjecting the substrate P to liquid immersion exposure before the substrate P is conveyed to the afore-mentioned liquid removing apparatus 1. FIG. 13 is a schematic diagram illustrating major parts of the exposure apparatus main body EX. In the present embodiment, description will be made based on an exemplary case wherein, as the exposure apparatus main body EX, use is made of a scan type exposure apparatus (what is called a scanning stepper) that exposes the pattern of the mask M on the substrate P while synchronously moving the mask M and the substrate P in the respective scanning directions (opposite directions).

Referring to FIG. 1, the illumination optical system IL includes an exposure light source, an optical integrator for making the illuminance of light beams projected from the exposure light source uniform, a condenser lens for collecting exposure light EL coming from the optical integrator, a relay lens array, a field diaphragm for setting an illumination region of the exposure light EL on the mask M, and so forth. The illumination optical system IL is adapted to illuminate the illumination region on the mask M with the exposure light EL of uniform illuminance distribution. As the exposure light EL emitted from the illumination optical system IL, use is made of, e.g., deep ultraviolet light (DUV light) such as emission lines (a g-ray, a h-ray and an i-ray) emitted from a mercury lamp, KrF excimer laser light (with a wavelength of 248nm) or the like and vacuum ultraviolet light (VUV light) such as ArF excimer laser light (with a wavelength of 193nm), F₂ laser light ((with a wavelength of 157nm) or the like. The ArF excimer laser light is utilized in the present embodiment.

As described earlier, in the present embodiment, pure water is used as the liquid LQ filling the light path space K1. The pure water permits transmission of, e.g., distant ultraviolet light (DUV light) such as emission lines (a g-line, a h-line and an i-line) emitted from a mercury lamp, KrF excimer laser light (with a wavelength of 248nm) or the like, as well as ArF excimer laser light.

The mask stage MST is capable of holding and moving the mask M. While holding the mask M in place, the mask stage MST can be two-dimensionally moved within a plane perpendicular to the optical axis AX of the projection optical system PL, i.e., within an X-Y plane and also can be finely rotated in the θZ direction by a mask stage drive unit MSTD, including a linear motor or the like, controlled by the control unit CONT. A movable mirror 91 is provided on the mask stage MST and a laser interferometer 92 is provided in a position oppositely facing the movable mirror 91. The position in the two-dimensional direction and the rotation angle in the θZ direction (possibly including rotation angles in the θX and θX directions) of the mask M placed on the mask stage MST are measured by means of the laser interferometer 92 on a real time basis. The measurement result of the laser interferometer 92 is outputted to the control unit CONT. Based on the measurement result from the laser interferometer 92, the control unit CONT controls the position of the mask M held in place on the mask stage MST, through the mask stage drive unit MSTD.

The projection optical system PL is adapted to project the pattern image of the mask M on the substrate P with a predetermined projection magnification ratio β. The projection optical system PL includes a plurality of optical elements, wherein the optical elements are kept in place by a lens barrel PK. In the present embodiment, the projection optical system PL is a reduction system whose projection magnification ratio β is equal to, e.g., 1/4, 1/5 or 1/8. Alternatively, the projection optical system PL may be either an equal magnification system or an enlargement system. Moreover, in the present embodiment, among the plurality of optical elements included in the projection optical system PL, a first optical element LS1 lying nearest to an image plane of the projection optical system PL is exposed to the outside from the lens barrel PK.

Referring to FIGS. 1 and 13, the substrate stage PST is provided with a substrate holder PH for holding the substrate P. The substrate holder PH is adapted to hold the substrate P by virtue of, e.g., a vacuum suction mechanism. A recess portion 96 is provided on the substrate stage PST, and the substrate holder PH for holding the substrate P is arranged in the recess portion 96. And, the upper surface 97 of the substrate stage PST around the recess portion 96 is formed into a planar surface having substantially the same height as (or flush with) the front surface Pa of the substrate P held on the substrate holder PH.

The substrate holder PH includes a base member 80, a plurality of protruding portions 81 formed on the base member 80 and adapted to support the rear surface Pb of the substrate P, and a peripheral wall portion 82 formed on the base member 80 and adapted to face the rear surface Pb of the substrate P and also to enclose the protruding portions 81. The peripheral wall portion 82 is formed in a generally annular shape similar to the shape of the substrate P and has a top surface facing the edge region Eb of the rear surface Pb of the substrate P. Furthermore, suction ports not shown in the drawings are uniformly arranged in plural numbers on the base member 80 inside the peripheral wall portion 82. Each of the plurality of suction ports is connected to a vacuum system. The control unit CONT operates the vacuum system to suck up (evacuate) the gas (air) in a space 83 enclosed by the substrate P, the peripheral wall portion 82 and the base member 80. By doing so, a pressure due to a vacuum generated in the space 83 is exerted on the substrate P, whereby the rear surface Pb of the substrate P is pressed to be sucked up against the protruding portions 81. The rear surface Pb of the substrate P makes close contact with the top surface of the peripheral wall portion 82 when the rear surface Pb of the substrate P is pressed to be sucked up against the protruding portions 81.

Holding the substrate P by use of the substrate holder PH, the substrate stage PST can be two-dimensionally moved along the base member BP within the X-Y plane and also can be finely rotated in a θZ direction by means of the substrate stage drive unit PSTD, including a linear motor and the like, controlled by the control unit CONT. In addition, the substrate stage PST is movable in Z-axis, θX and θX directions. Thus, the surface of the substrate P supported on the substrate stage PST can be moved with six degrees of freedom of movement in the X-axis, Y-axis, Z-axis, θX, θX and θZ directions. A movable mirror 93 is provided on a side surface of the substrate stage PST and a laser interferometer 94 is provided in a position oppositely facing the movable mirror 93. The two-dimensional direction position of the substrate P placed on the substrate stage PST and the rotation angle thereof are measured by means of the laser interferometer 94 on a real time basis. The exposure apparatus main body EX further includes an oblique incidence type focus leveling detection system for detecting information on the position of an upper surface of the substrate P supported on the substrate stage PST. The measurement result from the laser interferometer 94 is outputted to the control unit CONT. Also, the measurement result from the focus leveling detection system is outputted to the control unit CONT. Based on the measurement result of the focus leveling detection system, the control unit CONT operates the substrate stage drive unit PSTD and controls the focus position (Z-axis position) and the inclination angles (θX and θX) of the substrate P to thereby align the upper surface of substrate P with the image plane of the projection optical system PL. Based on the measurement result from the laser interferometer 94, the control unit CONT controls the position of the substrate P in the X-axis, Y-axis and θZ directions.

The liquid supply part 31 of the liquid immersion mechanism 100 includes a tank for storing the liquid LQ, a compression pump, a temperature control unit for controlling the temperature of the liquid LQ supplied, a filter unit for removing foreign materials present in the liquid LQ, and so forth. The liquid supplying operation of the liquid supply part 31 is controlled by the control unit CONT. Furthermore, it is not imperative for the exposure apparatus EX-SYS to possess the tank, the compression pump, the temperature control unit and the filter unit of the liquid supply part 31 in their entirety. Facilities existing in a factory in which the exposure apparatus EX-SYS is installed may be utilized in place thereof.

The liquid recovery part 41 includes a vacuum system (suction device) such as a vacuum pump or the like, a gas-liquid separator for separating the liquid LQ and the gas recovered, a tank for storing the thus-recovered liquid LQ, and so forth. The liquid recovery operation of the liquid recovery part 41 is controlled by the control unit CONT. It is not imperative for the exposure apparatus EX-SYS to possess the vacuum system, the gas-liquid separator and the tank of the liquid recovery part 41 in their entirety. Facilities existing in a factory in which the exposure apparatus EX-SYS is installed may be utilized in place thereof.

The supply ports 32 for supply of the liquid LQ and the recovery ports 42 for recovery of the liquid LQ are formed on a lower surface of the nozzle member 70. The nozzle member 70 is an annular member adapted to enclose a side surface of the first optical element LS1. The supply ports 32 are provided in plural numbers so that they can surround the first optical element LS1 of the projection optical system PL (the optical axis AX of the projection optical system PL). Moreover, the recovery ports 42 are provided more outwardly than the supply ports 32 with respect to the first optical element LS1 so that they can surround the first optical element LS1 and the supply ports 32.

At the time of forming the liquid immersion region LR of the liquid LQ, the control unit CONT operates both the liquid supply part 31 and the liquid recovery part 41. Once being supplied from the liquid supply part 31 under the control of the control unit CONT, the liquid LQ flows through the supply pipe 33 to be fed to the image plane side of the projection optical system PL from the supply ports 32 via the supply flow path of the nozzle member 70. Furthermore, if the liquid recovery part 41 is operated under the control of the control unit CONT, the liquid LQ present on the image plane side of the projection optical system PL is introduced into the recovery flow path of the nozzle member 70 through the recovery ports 42 and is then collected in the liquid recovery part 41 through the recovery pipe 43.

At least during the time when the pattern image of the mask M is projected on the substrate P, the control unit CONT fills the liquid LQ into the light path space K1 of the exposure light EL between the projection optical system PL and the substrate P held on the substrate holder PH by use of the liquid immersion mechanism 100. The substrate P is exposed to the exposure light EL irradiated on the substrate P through the projection optical system PL and the liquid LQ.

In the event that the edge region Eb of the rear surface Pb of the substrate P is subjected to liquid immersion exposure, for instance, it is often the case that the liquid immersion region LR of the liquid LQ lies on the gap Ge formed between the front surface Pa of the substrate P held on the substrate holder PH and the upper surface 97 of the substrate stage PST. If such is the case, there is a possibility that the liquid LQ infiltrates into the gap Ge and also into the side of the rear surface Pb of the substrate P. As described above, since the rear surface Pb of the substrate P makes close contact with the surface of the peripheral wall portion 82 when the substrate P is held on the substrate holder PH, there is a high possibility that the liquid LQ infiltrating into the gap Ge and entering the side of the rear surface Pb of the substrate P adheres predominantly to the edge region Eb of the rear surface Pb of the substrate P (a region outside the peripheral wall portion 82). There is a further possibility that the liquid LQ infiltrates into the space 83 through between the rear surface Pb of the substrate P and the top surface of the peripheral wall portion 82 of the substrate holder PH and then adheres to the center portion of the rear surface Pb of the substrate P. The control unit CONT unloads the substrate P, which has been subjected to the liquid immersion treatment, from the substrate holder PH by use of the second conveyor system H2 and, subsequently, transports it to the liquid removing apparatus 1 of the first to fourth embodiments set forth above, after which the treatment of removing the liquid LQ adhering to the rear surface Pb of the substrate P is performed by the liquid removing apparatus 1.

Although the liquid removing apparatus 1 is mounted to the exposure apparatus EX-SYS in the foregoing embodiments, it may be disposed on the coater/developer apparatus C/D-SYS. Alternatively, the liquid removing apparatus 1 may be disposed on the interface part IF.

Furthermore, in the foregoing embodiments, an inspection device for inspecting adherence of the liquid LQ to the rear surface Pb of the substrate P which has undergone the liquid immersion treatment may be disposed on the exposure apparatus EX-SYS to ensure that the exposed substrate P is conveyed to the afore-mentioned liquid removing apparatus 1 only when the liquid LQ adhered to the rear surface Pb of the substrate P is impermissible.

As set forth above, the liquid LQ used in the present embodiment is pure water. The pure water provides an advantage that it can be easily acquired in large quantities in a semiconductor fabricating factory and the like, and does not adversely affect a photoresist on the substrate P or an optical element (lens). Moreover, the pure water has no adverse effect on the environment and contains an extremely small amount of impurities, which comes up to an expectation that the pure water serves to cleanse the surface of the substrate P and the surface of the optical element provided on the tip end surface of the projection optical system PL.

And, the pure water (typical water) is said to have a refractive index "n" of about 1.44 with respect to the exposure light EL whose wavelength is about 193nm. In case ArF excimer laser light (with a wavelength of 193nm) is used as the exposure light EL, the wavelength thereof on the substrate P is reduced to 1/n, i.e., 134nm, thus providing an increased resolution power. Furthermore, the depth of focus becomes "n" times, i.e., 1.44 times, as great as that in the air. Thus, the aperture number of the projection optical system PL can be further increased in case it is desirable to secure about the same depth of focus as is available in the air. This also helps to enhance the resolution power.

In the present embodiment, the optical element (lens) LS1 is attached to the tip end of the projection optical system PL. Optical characteristics, e.g., aberrations (a spherical aberration, a coma aberration and the like), of the projection optical system PL can be adjusted by means of this lens. Furthermore, the optical element attached to the tip end of the projection optical system PL may be either an optical plate used in adjusting the optical characteristics of the projection optical system PL or a parallel flat panel that permits transmission of the exposure light EL therethrough.

Furthermore, in the event that the flow of the liquid LQ creates a high pressure between the optical element at the tip end of the projection optical system PL and the substrate P, it may be possible to fixedly secure the optical element against any movement otherwise caused by the pressure, instead of making the optical element replaceable.

Furthermore, in the present embodiment, the liquid LQ is filled between the projection optical system PL and the surface of the substrate P. Instead, the liquid LQ may be filled, e.g., in a state that a glass cover formed of a parallel flat panel is attached to the surface of the substrate P.

Moreover, with the projection optical system of the foregoing embodiments, the light path space on the image plane side of the optical element arranged at the tip end thereof is filled with the liquid. Alternatively, it may be possible to employ a projection optical system in which the light path space on the mask side of the optical element arranged at the tip end thereof is also filled with the liquid, as disclosed in PCT International Publication No. WO 2004/019128.

Furthermore, other liquid than water may be used as the liquid LQ, although the liquid LQ is water in the present embodiment. As an example, in case a source of the exposure light EL is an F₂ laser that generates F₂ laser light with no ability to penetrate water, the liquid LQ may be, e.g., fluorine-based liquid, such as perfluorinated polyether (PFPE) and fluorinated oil, which can be penetrated through by the F₂ laser light. In this case, the portion making contact with the liquid LQ is subjected to a hydrophilic treatment by, e.g., forming a thin film on that portion with a material of low-polarity molecular structure including fluorine. In addition to the above, it may be possible to use, as the liquid LQ, a material (e.g., cedar oil) that permits transmission of the exposure light EL, has a refractive index as high as possible and exhibits stability with respect to the projection optical system PL or a photoresist coated on the surface of the substrate P.

Moreover, as the substrate P of the respective embodiments described above, it is possible to use not only a semiconductor wafer for the manufacture of semiconductor devices but also a glass substrate for display devices, a ceramics wafer for thin film magnetic heads and a original plate of mask or reticle (a synthetic quartz wafer or a silicon wafer) used in an exposure apparatus.

As for the exposure apparatus EX-SYS, the present invention may be applied to a step-and-repeat type projection exposure apparatus (a stepper) that collectively exposes the pattern of the mask M with the mask M and the substrate P being kept in a stopped state and sequentially moves the substrate P step by step, as well as a step-and-scan type scanning exposure apparatus (a scanning stepper) that scan-exposes the pattern of the mask M by synchronously moving the mask M and the substrate P.

Furthermore, as for the exposure apparatus EX-SYS, the present invention may be applied to an exposure apparatus of the type collectively exposing the reduced image of a first pattern on a substrate P by use of a projection optical system (e.g., a refraction type projection optical system with a reduction ratio of 1/8 but with no reflection element) in a state that the first pattern and the substrate P are kept nearly immovable. In this case and subsequent to the above process, the present invention may be applied to a stitching exposure apparatus by which the reduced image of a second pattern is partially overlapped with the first pattern and collectively exposed on the substrate P by use of the projection optical system in a state that the second pattern and the substrate P are kept nearly immovable. Moreover, as for the stitching exposure apparatus, the present invention may be applied to a step-and-stitch type exposure apparatus by which at least two patterns are transferred to the substrate P in a partially overlapped state and the substrate P is moved step by step.

The present invention may also be applied to a twin stage type exposure apparatus, as disclosed in Japanese Unexamined Patent Application, Publication No. H10-163099, Japanese Unexamined Patent Application, Publication No. H10-214783, Published Japanese Translation No. 2000-505958 of the PCT International Publication and so forth.

Furthermore, the present invention may be applied to an exposure apparatus that includes a substrate stage for holding a substrate and a measurement stage which carries a reference member with a reference mark and various kinds of photoelectric sensors, as disclosed in Japanese Unexamined Patent Application, Publication No. H11-135400.

Although the exposure apparatus employed in the foregoing embodiments is of the type locally filling the liquid between the projection optical system PL and the substrate P, the present invention may be applied to a liquid immersion exposure apparatus for performing exposure in a state that the entire surface of an exposure target substrate is soaked in the liquid, as disclosed in Japanese Unexamined Patent Application, Publication No. H06-124873, Japanese Unexamined Patent Application, Publication No. H10-303114, U.S. Patent No. 5,825,043 and so forth.

As for the kind of exposure apparatus EX-SYS, the present invention is not limited to the exposure apparatus for the manufacture of semiconductor devices that exposes a semiconductor device pattern on the substrate P but may be extensively applied to an exposure apparatus for the manufacture of liquid crystal display devices or for the manufacture of displays, an exposure apparatus for the manufacture of thin film magnetic heads, image pickup devices (CCD), reticles or masks, and other exposure apparatuses.

Furthermore, the present invention may be applied to an exposure apparatus using an electronic mask, as disclosed in, e.g., U.S. Patent No. 6,778,257, by which a transmission pattern, a reflection pattern or a light emitting pattern is formed based on an electronic data of the pattern to be exposed.

As described above, the exposure apparatus EX-SYS in accordance with the embodiments of the present invention is manufactured by assembling various subsystems, including the respective elements recited in the claims of the subject application, so as to maintain specified mechanical, electrical and optical accuracy. In order to assure the various kinds of accuracy, calibration is conducted before and after the assembly process to accomplish optical accuracy for various optical systems, mechanical accuracy for various mechanical systems and electrical accuracy for various electric systems. The process for assembling the various subsystems into the exposure apparatus includes the tasks of mechanically interconnecting the various subsystems, connecting wire lines of an electric circuit and connecting pipelines of a pneumatic pressure circuit. It is a matter of course that individual processes for assembling each of the subsystems precede the process for assembling the various subsystems into the exposure apparatus. Once the process for assembling the various subsystems into the exposure apparatus comes to an end, general calibration is executed to assure various kinds of accuracy for the exposure apparatus as a whole. Moreover, it is desirable that the exposure apparatus be manufactured in a clean room whose temperature and degree of cleanliness are controlled.

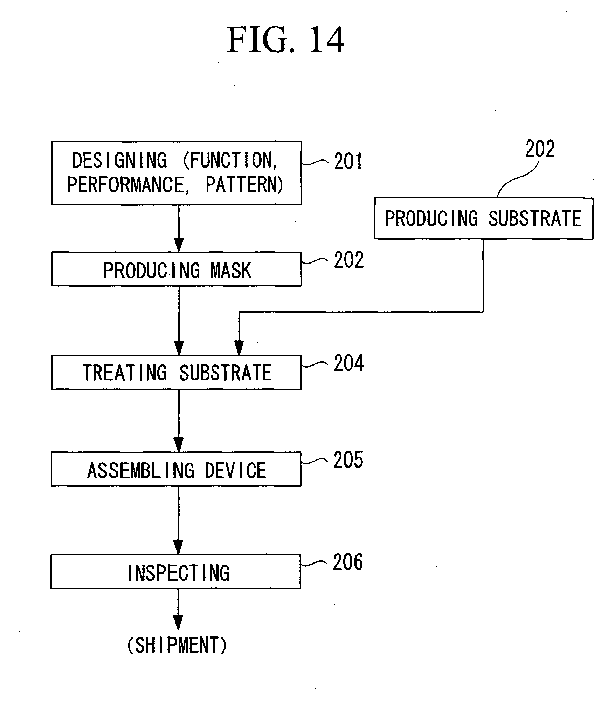

As illustrated in FIG. 14, micro devices such as semiconductor devices and the like are manufactured by way of a step 201 of designing a function, a performance and a pattern of the micro devices, a step 202 of producing a mask (reticle) based on the designing step, a step 203 of producing a substrate as a base member of the devices, a step 204 including a treatment by which a mask pattern is exposed on the substrate by means of the exposure apparatus EX-SYS of the foregoing embodiments, a step 205 of assembling the devices (including a dicing step, a bonding step and a packaging step) and an inspecting step 206.

## Claims

1. A liquid removing apparatus that removes liquid adhered to an exposure target substrate irradiated with exposure light through the liquid and taken out from a substrate holder, wherein a specified space is formed on a rear surface side of the exposure target substrate taken out from the substrate holder and wherein the liquid adhered to a rear surface of the exposure target substrate is removed by evacuating a gas present in the specified space through a suction port.

2. The liquid removing apparatus according to claim 1, wherein a gas stream moving toward the suction port is generated in the specified space by performing evacuation of the gas through the suction port and the liquid is recovered through the suction port by moving the liquid adhered to the rear surface of the exposure target substrate to the suction port by virtue of the gas stream.

3. The liquid removing apparatus according to claim 1 or 2, wherein the specified space is connected to an external space lying outside the specified space so that the gas can flow.

4. The liquid removing apparatus according to any one of claims 1 to 3, comprising a holder mechanism that holds the exposure target substrate so that the specified space is formed on the rear surface side of the exposure target substrate.

5. The liquid removing apparatus according to any one of claims 1 to 4, comprising a specified member having a prescribed surface facing the rear surface of the exposure target substrate, the specified space comprising a space between the rear surface of the exposure target substrate and the prescribed surface.

6. The liquid removing apparatus according to claim 5, wherein the suction port is provided at the prescribed surface.

7. The liquid removing apparatus according to claim 5 or 6, wherein the specified space is connected to the external space lying outside the specified space through a gap between an edge region of the rear surface of the exposure target substrate and the prescribed surface of the specified member.

8. The liquid removing apparatus according to claim 6, wherein the suction port is provided in a region of the prescribed surface facing a center portion of the rear surface of the exposure target substrate held on the holder mechanism.

9. The liquid removing apparatus according to claim 5 or 6, wherein a flow path is formed on the specified member so that the gas can flow between the specified space and the external space lying outside the specified space.

10. The liquid removing apparatus according to any one of claims 5 to 9, wherein the specified member has protruding portions provided at the prescribed surface, the protruding portions adapted to support the rear surface of the exposure target substrate to form a first gap between the rear surface of the exposure target substrate and the prescribed surface.

11. The liquid removing apparatus according to claim 10, wherein the first gap ranges from 10µm to 1mm.

12. The liquid removing apparatus according to any one of claims 5 to 11, comprising a guide member that guides the gas stream in the specified space.

13. The liquid removing apparatus according to claim 12, wherein the guide member is adapted to guide the gas stream moving toward the suction port.

14. The liquid removing apparatus according to claim 12 or 13, wherein the guide member is provided at the prescribed surface facing the rear surface of the exposure target substrate.

15. The liquid removing apparatus according to claim 14, wherein a second gap is formed between a top surface of the guide member and the rear surface of the exposure target substrate.

16. The liquid removing apparatus according to claim 15, wherein the second gap ranges from 2µm to 5µm.

17. The liquid removing apparatus according to any one of claims 12 to 16, wherein the specified space is divided into a plurality of partition spaces by the guide member, the suction port comprising a plurality of suction ports corresponding to the partition spaces, respectively.

18. The liquid removing apparatus according to claim 17, wherein the respective partition spaces are connected to the external space lying outside the partition spaces so that the gas can flow.

19. The liquid removing apparatus according to claim 17 or 18, wherein the respective partition spaces has a shape converging from the edge region of the rear surface of the exposure target substrate toward the center portion and adjoins to one another.

20. The liquid removing apparatus according to claim 19, wherein the respective partition spaces are connected near the edge region to the external space lying outside the partition spaces to allow the gas to flow through and the suction port is provided near the center portion.

21. The liquid removing apparatus according to claim 17 or 18, wherein the respective partition spaces are formed in an annular shape and arranged in a concentric pattern.

22. The liquid removing apparatus according to claim 21, wherein the suction port and the flow path communicating with the external space lying outside the partition spaces are provided in the specified space in a predetermined positional relationship.

23. The liquid removing apparatus according to any one of claims 1 to 22, wherein the specified space is formed so that the gas can flow along the rear surface of the exposure target substrate by evacuating the gas in the specified space.

24. An exposure apparatus comprising a substrate holder and the liquid removing apparatus according to any one of claims 1 to 23.

25. The exposure apparatus according to claim 24, comprising a conveyor system that conveys the exposure target substrate between the substrate holder and the liquid removing apparatus, wherein the conveyor system is adapted to hold a generally central portion of the rear surface of the exposure target substrate.

26. A device fabricating method comprising: using the exposure apparatus according to claim 24 or 25.
